(19) Europäisches Patentamt European Patent Office Office européen des brevets

(11) **EP 3 467 590 B1**

(12) **EUROPÄISCHE PATENTSCHRIFT**

(45) Veröffentlichungstag und Bekanntmachung des Hinweises auf die Patenterteilung:
**15.10.2025 Patentblatt 2025/42**

(21) Anmeldenummer: **18205398.3**

(22) Anmeldetag: **21.11.2014**

(51) Internationale Patentklassifikation (IPC):
***G03F 7/20*** *(2006.01)*

(52) Gemeinsame Patentklassifikation (CPC):
**G03F 7/70008; G03F 7/70058; G03F 7/702; G03F 7/70991;** G03F 7/70116

(54) **BELEUCHTUNGSSYSTEM FÜR DIE EUV-PROJEKTIONSLITHOGRAPHIE**

ILLUMINATION SYSTEM FOR EUV PROJECTION LITHOGRAPHY

SYSTÈME D'ÉCLAIRAGE POUR LITHOGRAPHIE PAR PROJECTION EUV

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.11.2013 DE 102013223935**

(43) Veröffentlichungstag der Anmeldung:
**10.04.2019 Patentblatt 2019/15**

(62) Dokumentnummer(n) der früheren Anmeldung(en) nach Art. 76 EPÜ:
**14802052.2 / 3 072 015**

(73) Patentinhaber: **Carl Zeiss SMT GmbH 73447 Oberkochen (DE)**

(72) Erfinder:
• **Patra, Michael 73447 Oberkochen (DE)**
• **Müller, Ralf 73430 Aalen (DE)**

(74) Vertreter: **Rau, Schneck & Hübner Patentanwälte Rechtsanwälte PartGmbB Königstraße 2 90402 Nürnberg (DE)**

(56) Entgegenhaltungen:
EP-A2- 1 225 481          DE-A1- 102008 014 832
US-A1- 2005 243 297

**Beschreibung**

Die Erfindung betrifft eine Strahlführungsoptik für ein Beleuchtungssystem für die EUV-Projektionslithographie. Außerdem betrifft die Erfindung ein Beleuchtungssystem für die EUV-Projektionslithographie und eine Projektionsbelichtungsanlage für die EUV-Lithographie. Schließlich betrifft die Erfindung ein Verfahren zur Herstellung eines strukturierten Bauteils sowie ein nach diesem Verfahren hergestelltes strukturiertes Bauteil.

Eine Projektionsbelichtungsanlage mit einem Beleuchtungssystem ist bekannt aus der US 2011/0 014 799 A1, aus der WO 2009/121 438 A1, aus der US 2009/0 174 876 A1, aus der US 6,438,199 B1 und der US 6,658,084 B2. Eine EUV-Lichtquelle ist bekannt aus der DE 103 58 225 B3 und der US 6,859,515 B. Weitere Komponenten für die EUV-Projektionslithografie sind bekannt aus der US 2003/0002022 A1, der DE 10 2009 025 655 A1, der US 6,700,952 und der US 2004/0140440 A. Weitere Referenzen, aus denen eine EUV-Lichtquelle bekannt ist, finden sich in der WO 2009/121 438 A1. EUV-Beleuchtungsoptiken sind weiterhin bekannt aus der US 2003/0043359 A1 und der US 5,896,438.

Aus der US 2005/0243297 A1 und der DE 10 2008 014 832 A1 sind Projektionsbelichtungsanlagen für die EUV-Lithographie bekannt.

Aus der EP 1 225 481 A2 ist ein Kollektor für ein Beleuchtungssystem einer EUV-Projektionsbelichtungsanlage bekannt.

Es sind Aufgaben der vorliegenden Erfindung, eine Strahlführungsoptik für ein Beleuchtungssystem für die EUV-Projektionslithographie sowie ein Beleuchtungssystem für die EUV-Projektionslithographie derart weiterzubilden, dass eine möglichst verlustfreie und gleichzeitig flexible Führung von EUV-Licht einer synchrotron-strahlungsbasierten Lichtquelle bereitgestellt ist.

Diese Aufgabe ist erfindungsgemäß gelöst durch eine Strahlführungsoptik mit den in Anspruch 1 angegebenen Merkmalen.

Eine Strahlführungsoptik nach Anspruch 1 ermöglicht es, die EUV-Strahlung durch eine vergleichsweise kleine Durchtrittsöffnung durch eine Blende oder eine Wand hindurchzuführen. Diese ermöglicht eine erwünschte Trennung zwischen verschiedenen Kammern, in denen die EUV-Strahlung geführt ist. Zudem können nach dem Zwischenfokus Baugruppen von Projektionsbelichtungsanlagen genutzt werden, die auf einen Zwischenfokus des EUV-Beleuchtungslichts mit vorgegebener numerischer Apertur abgestimmt sind.

Die Fokussier-Baugruppe ist so ausgeführt, dass für ein Verhältnis b/a aus einer kleinen Halbachse b des Ellipsoid-Spiegels und einer großen Halbachse a des Ellipsoid-Spiegels gilt: 0,7NA < b/a < 0,9NA, wobei NA die numerische Apertur im Zwischenfokus der Fokussier-Baugruppe bezeichnet.

Eine Fokussier-Baugruppe kann nach Art einer Wolter-Spiegelgruppe vom Typ I, vom Typ II oder vom Typ III ausgeführt sein. Die mindestens zwei Spiegel der Fokussier-Baugruppe können sequentiell im Strahlengang des EUV-Einzel-Ausgabestrahls angeordnet sein.

Die Fokussier-Baugruppe kann so ausgeführt sein, dass ein Bauraum der Fokussier-Baugruppe längs eines Strahlweges des EUV-Einzel-Ausgabestrahls etwa doppelt so groß ist wie eine große Halbachse eines Ellipsoid-Spiegels der Fokussier-Baugruppe. Die Fokussier-Baugruppe kann so ausgeführt sein, dass ein Bauraum der Fokussier-Baugruppe längs eines Strahlweges des EUV-Einzel-Ausgabestrahls etwa fünfzig Mal so groß ist wie ein Durchmesser des EUV-Einzel-Ausgabestrahls beim Eintritt in die Fokussier-Baugruppe.

Die Fokussier-Baugruppe kann so ausgeführt sein, dass sie mindestens einen Paraboloid-Spiegel aufweist, wobei für ein Verhältnis a/f aus einer großen Halbachse a des Ellipsoid-Spiegels und einer Brennweite f des Paraboloid-Spiegels gilt: a/f > 50.

Die Fokussier-Baugruppe kann so ausgeführt sein, dass ein geringster Ablenkwinkel, den ein Randstrahl des EUV-Einzel-Ausgabestrahls durch die Fokussier-Baugruppe erfährt, nicht größer ist als 5°.

Die Strahlführung von EUV-Licht bzw. EUV-Strahlung, bereitgestellt von einer synchrotron-strahlungsbasierten Lichtquelle, erfordert aufgrund der Eigenschaften des von einer derartigen Lichtquelle emittierten EUV-Rohstrahls eine spezifische Aufbereitung. Diese Aufbereitung wird durch die erfindungsgemäße Strahlformungsoptik, die Auskoppeloptik sowie die Strahlführungsoptik sowie durch die einzelnen strahlführenden Komponenten, nämlich die Umlenkoptik und die Fokussier-Baugruppe gewährleistet.

Bei der synchrotron-strahlungsbasierten Lichtquelle kann es sich um einen Freie-Elektronen-Laser (FEL), um einen Undulator, um einen Wiggler oder um einen Röntgenlaser handeln. Die synchrotron-strahlungsbasierte Lichtquelle kann einen Lichtleitwert kleiner als $0,1\text{mm}^2$ oder einen noch kleineren Lichtleitwert aufweisen. Die erfindungsgemäßen Optiken können generell mit der Emission einer Lichtquelle mit einem derart kleinen Lichtleitwert arbeiten, unabhängig davon, ob es sich um eine synchrotron-strahlungsbasierte Lichtquelle handelt.

Die Strahlformungsoptik sorgt für eine Vorformung eines Sammel-Ausgabestrahls aus dem Rohstrahl zur Vorbereitung einer nachfolgenden Auskopplung über die Auskoppeloptik in Einzel-Ausgabestrahlen. Letztere werden durch die Strahlführungsoptik zum jeweiligen Objektfeld geführt. Es resultiert die Möglichkeit, mit ein und derselben synchrotron-strahlungsbasierten Lichtquelle eine Mehrzahl von Objektfeldern zu beleuchten, was wiederum zur Möglichkeit führt, eine Mehrzahl von Projektionsbelichtungsanlagen, mit denen mikro- bzw. nanostrukturierte Bauelemente, zum Beispiel Halbleiterchips, insbesondere Speicherchips, hergestellt werden können, über ein und dieselbe synchrotron-strahlungsbasierte Lichtquelle zu versorgen.

Über die Auskoppeloptik und die nachfolgende Strahlführungsoptik lässt sich eine variable Intensitätsverteilung für die Anteile der Strahlungsleistung in den verschiedenen EUV-Einzel-Ausgabestrahlen gewährleisten. Hierdurch kann eine Anpassung an die Anzahl der zu versorgenden Projektionsbelichtungsanlagen sowie eine Anpassung an die von der jeweiligen Projektionsbelichtungsanlage geforderte Lichtleistung erfolgen. Auch unterschiedliche Anforderungen, die zur Herstellung spezifischer Strukturen an die jeweils hierfür erforderliche Lichtleistung bestehen, können dann durch entsprechende Anpassung des Beleuchtungssystems erfüllt werden.

Eine Umlenkoptik umfasst mindestens vier Umlenkspiegel für streifenden Einfall.

Die Spiegel für streifenden Einfall sind für einen Einfallswinkel größer als 60° gestaltet. Der Einfallswinkel kann noch größer sein.

Mindestens einer der Umlenkspiegel für streifenden Einfall kann als konvexer Zylinderspiegel ausgeführt sein. Mindestens einer der Umlenkspiegel für streifenden Einfall kann als konkaver Zylinderspiegel ausgeführt sein. Ausführungen der Umlenkoptik können eine größere Anzahl konkaver Zylinderspiegel als konvexe Zylinderspiegel aufweisen.

Ein parallel in die Umlenkoptik einfallender EUV-Strahl, insbesondere ein EUV-Einzel-Ausgabestrahl, kann nach Verlassen der Umlenkoptik eine Divergenz von weniger als 1mrad haben. Eine derartige Gestaltung der Umlenkoptik ermöglicht es, den EUV-Strahl über große Entfernung führen zu können.

Bei der Umlenkoptik lässt sich ein durch die Umlenkoptik erzeugter Aspektverhältnisbeitrag der Strahlführungsoptik an einen Vorgabewert anpassen. Beispielsweise lässt sich ein Aufweitfaktor für das Aspektverhältnis zwischen einem Wert 4 und einem Wert 5 oder zwischen einem Wert 1,5 und einem Wert 2 insbesondere stufenlos verändern. Mindestens einer der Umlenkspiegel für streifenden Einfall der Umlenkoptik kann mit angetrieben veränderbarem Krümmungsradius ausgeführt sein. Hierdurch lässt sich eine weitere Anpassung der optischen Wirkung der Umlenkoptik an einen Vorgabewert erreichen.

Bei einer Strahlformungsoptik können die Gruppen-Einfallsebenen aufeinander senkrecht stehen. Spiegelgruppen der Strahlformungsoptik können zwei Spiegel, drei Spiegel oder noch mehr Spiegel aufweisen. Durch den Einsatz mehrer Spiegelgruppen mit verschiedenen Gruppen-Einfallsebenen kann die EUV-Strahlung in zwei Querdimensionen unabhängig zur Erzeugung eines gewünschten Aspektverhältnisses beeinflusst werden.

Die Spiegelgruppen können nach Art von Galilei-Teleskopen gestaltet sein.

Die Spiegel der Strahlformungsoptik können als z. B. konvexe oder konkave Zylinderspiegel ausgeführt sein.

Die Spiegel für streifenden Einfall sind für einen Einfallswinkel größer als 60° gestaltet. Der Einfallswinkel kann noch größer sein.

Eine Anordnung, bei welcher alle Spiegel einer der Spiegelgruppen im Strahlengang nach einem ersten Spiegel einer weiteren Spiegelgruppe und vor einem letzten Spiegel dieser weiteren Spiegelgruppe angeordnet sind, schafft die Möglichkeit, einen großen Abstand zwischen denjenigen Spiegeln ein und derselben Spiegelgruppe zu schaffen, die zur Erzeugung eines gewünschten Aspektverhältnisses beispielsweise einen großen Aufweitfaktor bereitstellen müssen.

Einfallswinkel der EUV-Strahlung, welche auf allen Spiegeln einer Spiegelgruppe gleich groß sind, ermöglichen eine Transmissions-Optimierung für die EUV-Strahlung beim Durchgang durch die Strahlformungsoptik.

Einfallswinkel, welche auf mindestens zwei Spiegeln einer der Spiegelgruppen verschieden sind, erhöhen eine Flexibilität bei der Auslegung der Strahlformungsoptik und ermöglichen es beispielsweise, einen streifenden Einfall so an einen vorgegebenen Strahldurchmesser des einfallenden EUV-Strahls anzupassen, dass eine Spiegelgröße innerhalb vorgegebener Dimensionen bleibt.

Eine Gestaltung der Strahlformungsoptik, bei welcher projiziert auf die Gruppen-Einfallsebene der Spiegelgruppe mit verschiedenen Einfallswinkeln der erzeugte EUV-Sammel-Ausgabestrahl in der gleichen Richtung verläuft wie der EUV-Rohstrahl, der in die Strahlformungsoptik einfällt, ermöglicht es beispielsweise, sowohl den in die Strahlformungsoptik einfallenden als auch den aus der Strahlformungsoptik ausfallenden Strahl horizontal zu führen.

Eine Divergenz des EUV-Sammel-Ausgabestrahls kann kleiner sein als eine halbe Divergenz des EUV-Rohstrahls. Eine entsprechende Gestaltung der Strahlformungsoptik ermöglicht es, den EUV-Sammel-Ausgabestrahl über große Entfernung führen zu können.

Mindestens ein Spiegel der Strahlformungsoptik kann eine Abweichung von mindestens $5\mu m$ von einem bestangepassten (best fit) Kegelschnitt haben. Mindestens ein Spiegel der Strahlformungsoptik kann als Freiformfläche ausgeführt sein. Entsprechende Spiegelgestaltungen der Strahlformungsoptik erhöhen die Freiheitsgrade, um eine optische Wirkung der Strahlformungsoptik an Vorgabewerte anzupassen.

Die Aufgabe wird weiter gelöst durch ein Beleuchtungssystem mit einer Strahlführungsoptik gemäß der vorhergehenden Beschreibung. Die Vorteile ergeben sich aus den für die jeweiligen Komponenten beschriebenen.

Ein Beleuchtungssystem mit einer Strahlformungsoptik und einer Auskoppeloptik nach Anspruch 9 ermöglicht die Bereitstellung einer Mehrzahl von EUV-Einzel-Ausgabestrahlen mit vorgegebenem Aspektverhältnis eines EUV-Strahldurchmessers. Die von der Strahlformungsoptik einerseits und von der Auskoppeloptik und der nachfolgenden Strahlführungsoptik andererseits bereitgestellten Aspektverhältnisbeiträge können noch mit einem gewünschten Soll-Aspektverhältnis multipliziert werden, zum Beispiel mit dem Aspektverhältnis eines zu beleuchtenden Objektfeldes. Das Erzeugen eines gewünschten Aspektverhältnisbeitrages der mehreren Einzel-Ausgabestrahlen von 1:1 wird, ausgehend vom Rohstrahl, verteilt einerseits auf die Erzeugung eines Aspektverhältnisbeitrages ungleich 1 über die Strahlformungsoptik sowie, nach dem Aufteilen des Sammel-Ausgabestrahls in die mehreren Einzel-Ausgabestrahlen, durch die Erzeugung eines entsprechenden Aspektverhältnisbeitrages durch die Auskoppeloptik und die Strahlführungsoptik. Dies ermöglicht auf dem Weg des EUV-Beleuchtungslichts von der Lichtquelle bis zum Objektfeld moderate Aspektverhältnis-Änderungen, die durch die verschiedenen optischen Baugruppen, die der EUV-Strahl durchläuft, herbeigeführt werden müssen. Alternativ kann mit der Strahlformungsoptik zunächst auch ein anderer Aspektverhältnisbeitrag erzeugt werden, beispielsweise ein Aspektverhältnisbeitrag von 1:N für N EUV-Einzel-Ausgabestrahlen. Eine nachfolgende Auskoppeloptik muss den so erzeugten EUV-Sammel-Ausgabestrahl dann noch aufteilen, benötigt dann aber zur Vorgabe der EUV-Einzel-Ausgabestrahlen mit dem Aspektverhältnisbeitrag von jeweils 1:1 keine eigene aspektverhältnisbeeinflussende Wirkung. Auch eine andere Verteilung der Aspektverhältnisbeiträge, die von der Strahlformungsoptik einerseits und von der Auskoppeloptik bzw. der Strahlführungsoptik andererseits erzeugt werden, zur Erzeugung einer Anzahl N von EUV-Einzel-Ausgabestrahlen mit einem Aspektverhältnisbeitrag von jeweils 1:1, ist möglich.

Die Vorteile einer Projektionsbelichtungsanlage nach Anspruch 12, eines Herstellungsverfahrens nach Anspruch 13 und eines verfahrensgemäß strukturierten Bauteils entsprechen denen, die vorstehend unter Bezugnahme auf die vorhergehenden Ansprüche bereits erläutert wurden.

Bei der Lichtquelle des Beleuchtungssystems kann es sich um einen Freie-Elektronen-Laser (FEL), um einen Undulator, um einen Wiggler oder um einen Röntgenlaser handeln.

Der EUV-Sammel-Ausgabestrahl kann innerhalb eines Nutzquerschnitts eine Intensitätsverteilung aufweisen, die in jedem Punkt des Nutzquerschnitts von einer homogenen Intensität um weniger als 10 % abweicht. Eine entsprechende Homogenität kann ein jeweiliger EUV-Einzel-Ausgabestrahl nach der Umlenkoptik aufweisen.

Alle Spiegel des Beleuchtungssystems können hochreflektierende Beschichtungen tragen.

Die Strahlformungsoptik, die Umlenkoptik und die Fokussier-Baugruppe sind Baugruppen, die auch eigenständig, also ohne die weiteren Baugruppen des Beleuchtungssystems, erfindungswesentlich sind.

Alle Anspruchsmerkmale können auch in anderer Kombination miteinander kombiniert werden.

Die Erfindung wird durch die Ansprüche definiert.

Ausführungsbeispiele der Erfindung werden nachfolgend anhand der Zeichnung näher erläutert. In dieser zeigen:

| | |
|---|---|
| Fig. 1 | schematisch eine Projektionsbelichtungsanlage für die EUV-Projektionslithographie; |
| Fig. 2 | ebenfalls schematisch einen führenden Abschnitt eines EUV-Strahlengangs für ein System mehrerer Projektionsbelichtungsanlagen nach Fig. 1, ausgehend von einer EUV-Lichtquelle zur Erzeugung eines EUV-Rohstrahls bis nach einer Auskoppeloptik zur Erzeugung mehrerer EUV-Einzel-Ausgabestrahlen aus einem EUV-Sammel-Ausgabestrahl; |
| Fig. 3 | Querschnittsverhältnisse der EUV-Strahlung im Verlauf des EUV-Strahlengangs zwischen der Lichtquelle und der Bündelführung in einer einem Objektfeld der Projektionsbelichtungsanlage vorgelagerten Beleuchtungsoptik; |
| Fig. 4 | eine Seitenansicht einer Strahlformungsoptik zur Erzeugung des EUV-Sammel-Ausgabestrahls aus dem EUV-Rohstrahl; |
| Fig. 5 | eine weitere Seitenansicht aus Richtung V in Fig. 4; |
| Fig. 6 und 7 | stark schematisch die Strahlformungsoptik nach den Fig. 4 und 5 zur Verdeutlichung von Umlenkwinkeln, die von Spiegeln der Strahlformungsoptik hervorgerufen werden; |
| Fig. 8 und 9 | in einer zu den Fig. 6 und 7 ähnlichen Darstellung eine weitere Ausführung einer Strahlformungsop-tik; |
| Fig. 10 und 11 | in einer zu den Fig. 6 und 7 ähnlichen Darstellung eine weitere Ausführung einer Strahlformungsoptik; |
| Fig. 12 | weniger schematisch als in den Fig. 1 und 2 einen EUV-Strahlengang zwischen der Strahlformungsoptik und einer Umlenkoptik als Teil einer Strahlführungsoptik zur Führung des jeweiligen EUV-Einzel-Ausgabestrahls hin zum Objektfeld, wobei die Umlenkoptik der Auskoppeloptik im Strahlengang des EUV-Einzel-Ausgabestrahls nachgeordnet ist; |
| Fig. 13 | in einem Schnitt parallel zur Einfallsebene auf den Umlenkspiegeln stark schematisch eine Ausführung der Umlenkoptik mit im Strahlengang des EUV-Einzel-Ausgabestrahls zunächst zwei konvexen Zylinderspiegeln, einem nachfolgenden Planspiegel und drei nachfolgenden konkaven Zylinderspiegeln; |
| Fig. 14 | in einer zu Fig. 13 ähnlichen Darstellung eine weitere Ausführung der Umlenkoptik mit einem konvexen Zylinderspiegel und im EUV-Strahlengang sich sequentiell anschließenden drei konkaven Zylinderspiegeln; |

Fig. 15        in einer zu Fig. 13 ähnlichen Darstellung eine weitere Ausführung der Umlenkoptik mit sequentiell im EUV-Strahlengang nacheinander angeordnet einem konvexen Zylinderspiegel, einem Planspiegel und zwei konkaven Zylinderspiegeln;

Fig. 16        in einer zu Fig. 13 ähnlichen Darstellung eine weitere Ausführung der Umlenkoptik mit sequentiell im EUV-Strahlengang nacheinander angeordnet einem konvexen Zylinderspiegel, einem Planspiegel und drei konkaven Zylinderspiegeln;

Fig. 17        in einer zu Fig. 13 ähnlichen Darstellung eine weitere Ausführung der Umlenkoptik mit sequentiell im EUV-Strahlengang nacheinander angeordnet einem konvexen Zylinderspiegel, zwei nachfolgenden konkaven Zylinderspiegeln, einem nachfolgenden Planspiegeln und zwei nachfolgenden konkaven Zylinderspiegeln;

Fig. 18        in einer zu Fig. 13 ähnlichen Darstellung eine weitere Ausführung der Umlenkoptik mit sequentiell im EUV-Strahlengang nacheinander angeordnet einem konvexen Zylinderspiegel, einem nachfolgenden Planspiegel und vier sequentiell nachfolgenden konkaven Zylinderspiegeln;

Fig. 19        in einer zu Fig. 13 ähnlichen Darstellung eine weitere Ausführung der Umlenkoptik mit sequentiell im EUV-Strahlengang nacheinander angeordnet einem konvexen Zylinderspiegel, zwei sequentiell nachfolgenden Planspiegeln und drei sequentiell nachfolgenden konkaven Zylinderspiegeln;

Fig. 20        einen Ausschnitt des Strahlengangs eines der EUV-Einzel-Ausgabestrahlen zwischen der Umlenkoptik und einer Zwischenfokusebene zur Verdeutlichung der Funktion einer Fokussier-Baugruppe bzw. Einkoppeloptik der Strahlführungsoptik zur Führung des jeweiligen EUV-Einzel-Ausgabestrahls zum Objektfeld;

Fig. 21        in einer zu Fig. 20 ähnlichen Darstellung eine weitere Ausführung der Einkoppeloptik;

Fig. 22        eine Ausführung der Einkoppeloptik des Typs Wolter I;

Fig. 23        eine Ausführung der Einkoppeloptik des Typs Wolter II;

Fig. 24        eine Ausführung der Einkoppeloptik des Typs Wolter III;

Fig. 25        eine weitere Ausführung der Einkoppeloptik des Typs Wolter III,

Fig. 26 bis 28    unterschiedliche Varianten einer Strahlformungsoptik;

Fig. 29        eine schematische Darstellung einer Strahlaufweitungskomponente.

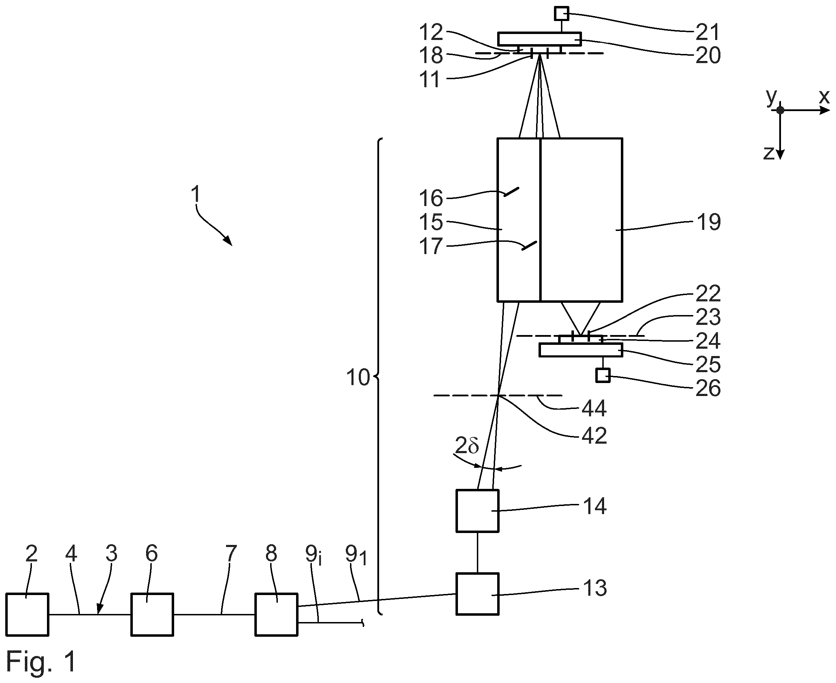

Eine Projektionsbelichtungsanlage 1 für die Mikrolithographie ist Teil eines Systems aus mehreren Projektionsbelichtungsanlagen, von denen in der Fig. 1 eine der Projektionsbelichtungsanlagen 1 dargestellt ist. Die Projektionsbelichtungsanlage 1 dient zur Herstellung eines mikro- bzw. nanostrukturierten elektronischen Halbleiter-Bauelements. Eine für alle Projektionsbelichtungsanlagen des System gemeinsame Licht- bzw. Strahlungsquelle 2 emittiert EUV-Strahlung im Wellenlängebereich beispielsweise zwischen 2 nm und 30 nm, insbesondere zwischen 2 nm und 15 nm. Die Lichtquelle 2 ist als Freie-Elektronen-Laser (FEL) ausgeführt. Es handelt sich dabei um eine Synchrotronstrahlungsquelle bzw. um eine synchrotron-strahlungsbasierte Lichtquelle, die kohärente Strahlung mit sehr hoher Brillanz erzeugt. Vorveröffentlichungen, in denen derartige FEL beschrieben sind, sind in der WO 2009/121 438 A1 angegeben. Eine Lichtquelle 2, die beispielsweise zum Einsatz kommen kann, ist beschrieben in Uwe Schindler "Ein supraleitender Undulator mit elektrisch umschaltbarer Helizität", Forschungszentrum Karlsruhe in der Helmholtz-Gemeinschaft, wissenschaftliche Berichte, FZKA 6997, August 2004, in der US 2007/0152171 A1 und in der DE 103 58 225 B3.

Die Lichtquelle 2 hat in einem Rohstrahl einen ursprünglichen Lichtleitwert, der kleiner ist als 0,1 mm$^2$. Beim Lichtleitwert handelt es sich um das kleinste Volumen eines Phasenraums, der 90 % der Lichtenergie einer Emission einer Lichtquelle enthält. Hierzu entsprechende Definitionen des Lichtleitwertes finden sich in der EP 1 072 957 A2 und der US 6 198 793 B1, in denen angegeben ist, dass der Lichtleitwert durch Multiplikation der Beleuchtungsdaten x, y und NA$^2$ erhalten ist, wobei x und y die Felddimensionen sind, die ein beleuchtetes Beleuchtungsfeld aufspannen und NA die numerische Apertur der Feldbeleuchtung. Auch noch kleinere Lichtleitwerte der Lichtquelle als 0,1 mm$^2$ sind möglich, beispielsweise ein Lichtleitwert kleiner als 0,01 mm$^2$.

Die EUV-Lichtquelle 2 hat eine Elektronenstrahl-Versorgungseinrichtung zur Erzeugung eines Elektronenstrahls und eine EUV-Generationseinrichtung. Letztere wird über die Elektronenstrahl-Versorgungseinrichtung mit dem Elektronenstrahl versorgt. Die EUV-Generationseinrichtung ist als Undulator ausgeführt. Der Undulator kann optional durch Verlagerung verstellbare Undulatormagnete aufweisen. Der Undulator kann Elektromagnete aufweisen. Auch ein Wiggler kann bei der Lichtquelle 2 vorgesehen sein.

Die Lichtquelle 2 hat eine mittlere Leistung von 2,5 kW. Die Pulsfrequenz der Lichtquelle 2 beträgt 30 MHz. Jeder einzelne Strahlungsimpuls trägt dann eine Energie von 83 μJ. Bei einer Strahlungsimpulslänge von 100 fs entspricht dies einer Strahlungsimpulsleistung von 833 MW.

Eine Repetitionsrate der Lichtquelle 2 kann im Kilohertzbereich, beispielsweise bei 100 kHz, oder im niedrigeren Megahertzbereich, beispielsweise bei 3 MHz, im mittleren Megahertzbereich, beispielsweise bei 30 MHz, im oberen Megahertzbereich, beispielsweise bei 300 MHz, oder auch im Gigaherzbereich, beispielsweise bei 1,3 GHz, liegen.

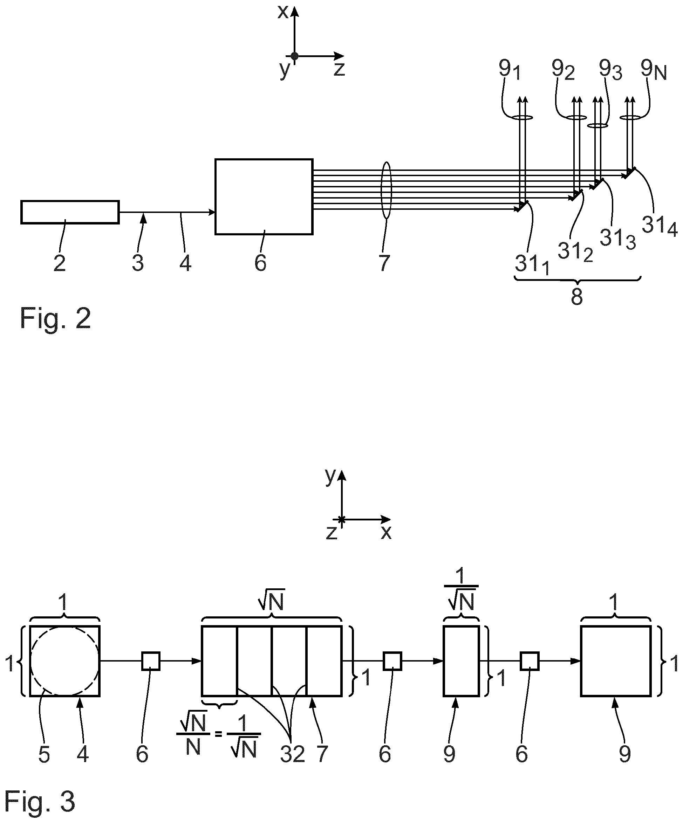

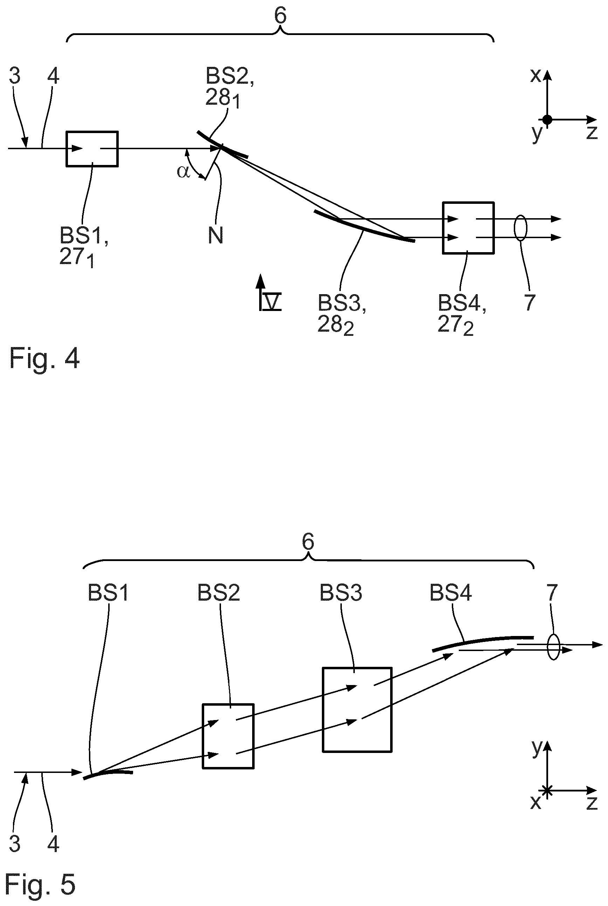

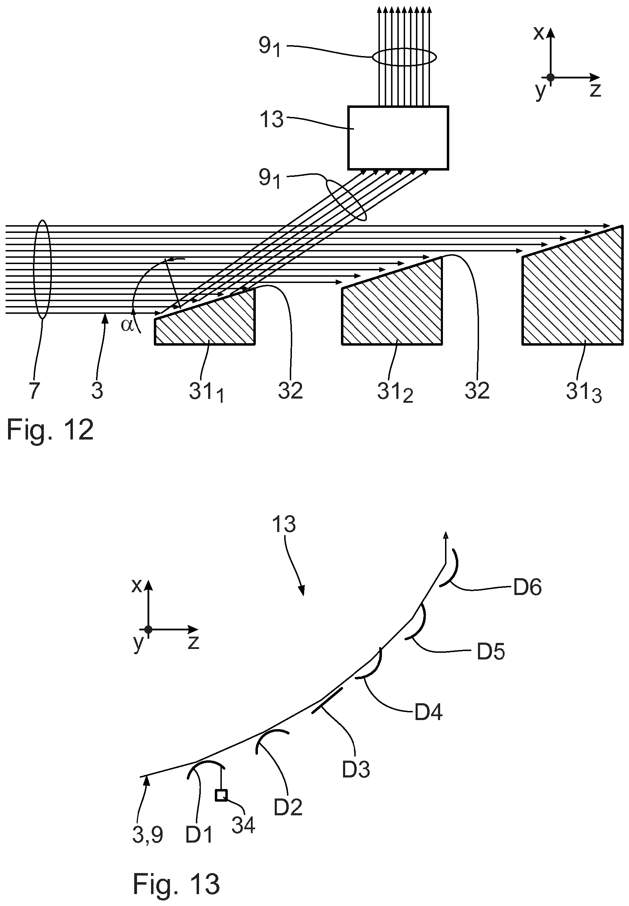

Zur Erleichterung der Darstellung von Lagebeziehungen wird nachfolgend ein kartesisches xyz-Koordinatensystem verwendet. Die x-Koordinate spannt mit der y-Koordinate bei diesen Darstellungen regelmäßig einen Bündelquerschnitt des EUV-Beleuchtungs- und Abbildungslichts 3 auf. Entsprechend verläuft die z-Richtung regelmäßig in der Strahlrichtung des Beleuchtungs- und Abbildungslichts 3. Die x-Richtung verläuft zum Beispiel in den Fig. 2 und 12 vertikal, also senkrecht zu Gebäudeebenen, in denen das System der Projektionsbelichtungsanlagen 1 untergebracht ist. Das Koordinatensystem der Fig. 4 bis 11 ist hierzu um 90° um die z-Achse verdreht.

Fig. 1 zeigt stark schematisch Hauptkomponenten einer der Projektionsbelichtungsanlagen 1 des Systems.

Die Lichtquelle 2 imitiert Beleuchtungs- und Abbildungslicht 3 in Form zunächst eines EUV-Rohstrahls 4. Fig. 3 zeigt stark schematisch links einen Querschnitt durch den EUV-Rohstrahl 4 mit einem x/y-Aspektverhältnis von 1:1. In der Regel liegt der Rohstrahl 4 als Bündel mit einem gaußförmigen Intensitätsprofil vor, also als im Querschnitt rundes Bündel, was in der Fig. 3 durch eine gestrichelte Begrenzungslinie 5 angedeutet ist. Der EUV-Rohstrahl 4 hat eine sehr kleine Divergenz.

Eine Strahlformungsoptik 6 (vgl. Fig. 1) dient zur Erzeugung eines EUV-Sammel-Ausgabestrahls 7 aus dem EUV-Rohstrahl 4. Dies ist in der Fig. 1 sehr stark schematisch und in der Fig. 2 etwas weniger stark schematisch dargestellt. Der EUV-Sammel-Ausgabestrahl 7 hat eine sehr kleine Divergenz. Fig. 3 verdeutlicht in der zweiten Querschnittsdarstellung von links wiederum ein Aspektverhältnis des EUV-Sammel-Ausgabestrahls 7. Dieses Aspektverhältnis wird von der Strahlformungsoptik 6 abhängig von einer Anzahl N der innerhalb des Systems mit der Lichtquelle 2 zu versorgenden Projektionsbelichtungsanlagen 1 vorgegeben. Das x/y-Aspektverhältnis, das durch die Strahlformungsoptik 6 erzeugt wird, beträgt im Allgemeinen $\sqrt{N}:1$, wobei ein rechteckiges Strahlprofil des Beleuchtungslichts 3 resultiert, wie in der Fig. 3 dargestellt. Der EUV-Sammel-Ausgabestrahl 7 hat die Form eines homogen ausgeleuchteten Rechtecks. Der Aspektverhältnisbeitrag $\sqrt{N}:1$ kann noch mit einem gewünschten Soll-Aspektverhältnis multipliziert werden, zum Beispiel mit dem Aspektverhältnis eines zu beleuchtenden Objektfeldes.

Fig. 2 deutet eine Systemauslegung mit N = 4 an, bei der die Lichtquelle 2 also vier Projektionsbelichtungsanlagen nach Art der Projektionsbelichtungsanlage 1 nach Fig. 1 mit dem Beleuchtungslicht 3 versorgt. Für N = 4 beträgt das x/y-Aspektverhältnis des EUV-Sammel-Ausgabestrahls 7 2:1. Die Anzahl N der Projektionsbelichtungsanlagen 1 kann auch noch größer sein und kann beispielsweise bis zu 10 betragen.

Bei einer alternativen Systemauslegung hat der EUV-Sammel-Ausgabestrahl ein x/y-Aspektverhältnis von N:1. Auch dieses Verhältnis kann noch mit einem gewünschten Soll-Aspektverhältnis multipliziert werden.

Eine Auskoppeloptik 8 (vgl. Fig. 1 und 2) dient zur Erzeugung von mehreren, nämlich von N, EUV-Einzel-Ausgabestrahlen $9_1$ bis $9_N$ (i = 1,... N) aus dem EUV-Sammel-Ausgabestrahl 7.

Die Fig. 1 zeigt die weitere Führung genau eines dieser EUV-Einzel-Ausgabestrahlen 9, nämlich des Ausgabestrahls $9_1$. Die anderen, von der Auskoppeloptik 8 erzeugten EUV-Einzel-Ausgabestrahlen $9_i$, die in der Fig. 1 ebenfalls schematisch angedeutet ist, werden anderen Projektionsbelichtungsanlagen des Systems zugeführt.

Nach der Auskoppeloptik 8 wird das Beleuchtungs- und Abbildungslicht 3 von einer Strahlführungsoptik 10 (vgl. Fig. 1) hin zu einem Objektfeld 11 der Projektionsbelichtungsanlage 1 geführt, indem eine Lithografiemaske 12 in Form eines Retikels als zu projizierendes Objekt angeordnet ist. Zusammen mit der Strahlführungsoptik 10 stellen die Strahlformungsoptik 6 und die Auskoppeloptik 8 ein Beleuchtungssystem für die Projektionsbelichtungsanlage 1 dar.

Die Strahlführungsoptik 10 umfasst in der Reihenfolge des Strahlengangs für das Beleuchtungslicht 3, also für den EUV-Einzel-Ausgabestrahl $9_i$, eine Umlenkoptik 13, eine Einkoppeloptik in Form einer Fokussier-Baugruppe 14 und eine nachgeschaltete Beleuchtungsoptik 15. Die Beleuchtungsoptik 15 beinhaltet einen Feldfacettenspiegel 16 und einen Pupillenfacettenspiegel 17, deren Funktion derjenigen entspricht, die aus dem Stand der Technik bekannt ist und die daher in der Fig. 1 lediglich äußerst schematisch und ohne zugehörigen EUV-Strahlengang dargestellt sind.

Nach Reflexion am Feldfacettenspiegel 16 trifft das in EUV-Strahlbüschel, die einzelnen, nicht dargestellten Feldfacetten des Feldfacettenspiegels 16 zugeordnet sind, aufgeteilte Nutzstrahlungsbündel des Beleuchtungslichts 3 auf den Pupillenfacettenspiegel 17. In der Fig. 1 nicht dargestellte Pupillenfacetten des Pupillenfacettenspiegels 17 sind rund. Jedem von einer der Feldfacetten reflektierten Strahlbüschel des Nutzstrahlungsbündels ist eine dieser Pupillenfacetten zugeordnet, so dass jeweils ein beaufschlagtes Facettenpaar mit einer der Feldfacetten und einer der Pupillenfacetten einen Ausleuchtungskanal bzw. Strahlführungskanal für das zugehörige Strahlbüschel des Nutzstrahlungsbündels vorgibt. Die kanalweise Zuordnung der Pupillenfacetten zu den Feldfacetten erfolgt abhängig von einer gewünschten Beleuchtung durch die Projektionsbelichtungsanlage 1. Das Beleuchtungslicht 3 ist also zur Vorgabe individueller Beleuchtungswinkel längs des Ausleuchtungskanals sequentiell über Paare aus jeweils einer der Feldfacetten und jeweils einer der Pupillenfacette geführt. Zur Ansteuerung jeweils vorgegebener Pupillenfacetten werden die Feldfacettenspiegel jeweils individuell verkippt.

Über den Pupillenfacettenspiegel 17 und ggf. über eine nachfolgende, aus zum Beispiel drei nicht dargestellten EUV-Spiegeln bestehende Übertragungsoptik werden die Feldfacetten in das Beleuchtungs- bzw. Objektfeld 11 in einer Retikel- bzw. Objektebene 18 einer in der Fig. 1 ebenfalls schematisch dargestellten Projektionsoptik 19 der Projektionsbelichtungsanlage 1 abgebildet.

Aus den einzelnen Beleuchtungswinkeln, die über alle Ausleuchtungskanäle über eine Beleuchtung der Feldfacetten des Feldfacettenspiegels 16 herbeigeführt werden, ergibt sich eine Beleuchtungswinkelverteilung der Beleuchtung des Objektfeldes 11 durch die Beleuchtungsoptik 15.

Bei einer weiteren Ausführung der Beleuchtungsoptik 15, insbesondere bei einer geeigneten Lage einer Eintrittspupille der Projektionsoptik 19, kann auf die Spiegel der Übertragungsoptik vor dem Objektfeld 11 auch verzichtet werden, was zu einer entsprechenden Transmissionserhöhung der Projektionsbelichtungsanlage 1 für das Nutzstrahlungsbündel führt.

In der Objektebene 18 im Bereich des Objektfeldes 11 ist das das Nutzstrahlungsbündel reflektierende Retikel 12 angeordnet. Das Retikel 12 wird von einem Retikelhalter 20 getragen, der über einen Retikelverlagerungsantrieb 21 angesteuert verlagerbar ist.

Die Projektionsoptik 19 bildet das Objektfeld 11 in ein Bildfeld 22 in einer Bildebene 23 ab. In dieser Bildebene 23 ist bei der Projektionsbelichtung ein Wafer 24 angeordnet, der eine lichtempfindliche Schicht trägt, die während der Projektionsbelichtung mit der Projektionsbelichtungsanlage 1 belichtet wird. Der Wafer 24 wird von einem Waferhalter 25 getragen, der wiederum über einen Waferverlagerungsantrieb 26 gesteuert verlagerbar ist.

Bei der Projektionsbelichtung werden sowohl das Retikel 12 als auch der Wafer 24 in der Fig. 1 in x-Richtung durch entsprechende Ansteuerung des Retikelverlagerungsantriebs 21 und des Waferverlagerungsantriebs 26 synchronisiert gescannt. Der Wafer wird während der Projektionsbelichtung mit einer Scangeschwindigkeit von typisch 600 mm/s in der x-Richtung gescannt.

Fig. 4 und 5 zeigen eine Ausführung der Strahlformungsoptik 6. Die Strahlformungsoptik 6 nach den Fig. 4 und 5 hat insgesamt vier Spiegel BS1, BS2, BS3 und BS4, die in der Reihenfolge ihrer Beaufschlagung durch das Beleuchtungslicht 3 durchnummeriert sind. Fig. 4 zeigt die Strahlformungsoptik 6 in einer Ansicht parallel zur xz-Ebene. Fig. 5 zeigt die Strahlformungsoptik 6 in einer Aufsicht parallel zur yz-Ebene.

Die Darstellung einer Strahlumlenkung durch die Spiegel BS1 bis BS4 der Strahlformungsoptik 6 ist in den Fig. 4 und 5 insoweit von der Realität abweichend, als die Spiegel BS1 und BS4 in der Fig. 4 und die Spiegel BS2 und BS3 in der Fig. 5 jeweils beide in der Aufsicht mit dem Betrachter zugewandter Reflexionsfläche dargestellt sind. Tatsächlich ist eine Reflexionsfläche des Spiegels BS4 in der Fig. 4 und eine Reflexionsfläche des Spiegels BS3 in der Fig. 5 vom Betrachter abgewandt.

Die Spiegel BS1 bis BS4 werden allesamt unter streifendem Einfall mit dem Beleuchtungslicht 3 beaufschlagt. Ein streifender Einfall liegt dann vor, wenn ein Einfallswinkel $\alpha$ zwischen einer Einfalls- bzw. Ausfalls-Hauptrichtung des Beleuchtungslichts 3 und einer Normalen N auf einen mit dem Beleuchtungslicht 3 beaufschlagten Reflexionsflächenabschnitt des jeweiligen Spiegels größer ist als 60°. Der Einfallswinkel $\alpha$ kann beispielsweise größer sein als 65°, kann größer sein als 70° und kann auch größer sein als 75°.

Die Strahlformungsoptik 6 nach den Fig. 4 und 5 hat zwei Strahlformungs-Spiegelgruppen 27, 28, nämlich einerseits die Strahlformungs-Spiegelgruppe 27 mit den Spiegeln BS1 und BS4, die in der Fig. 4 auch mit $27_1$ und $27_2$ bezeichnet sind, und die Strahlformungs-Spiegelgruppe 28 mit den Spiegeln BS2 und BS3, die in der Fig. 5 auch mit $28_1$ und $28_2$ bezeichnet sind. Jede Spiegelgruppe 27, 28 hat eine gemeinsame Gruppen-Einfallsebene. Die Einfallsebene der Spiegelgruppe 27 ist parallel zur yz-Ebene (Zeichenebene der Fig. 5). Die Gruppen-Einfallsebene der Spiegelgruppe 28 ist parallel zur xz-Ebene (Zeichenebene der Fig. 4). Die beiden Gruppen-Einfallsebenen yz und xz der Spiegelgruppen 27, 28 unterscheiden sich also voneinander und stehen bei der dargestellten Ausführung senkrecht aufeinander.

Die Strahlformungs-Spiegelgruppe 27 dient zur Strahlformung des EUV-Sammel-Ausgabestrahls 7 in der yz-Ebene. Die Strahlformungs-Spiegelgruppe 28 dient zur Strahlformung des EUV-Sammel-Ausgabestrahl 7 in der xz-Ebene.

Die Strahlformungs-Spiegelgruppen 27 einerseits und 28 andererseits haben prinzipiell die Wirkung eines Galilei-Zylinderteleskops. Um eine Umformung des Strahlprofils zu erreichen, zum Beispiel aus einen im wesentlichen runden Rohstrahl 4 mit einem gaußförmigen Intensitätsprofil in einen im wesentlichen rechteckigen EUV-Sammel-Ausgabestrahl 7 mit homogenem Intensitätsprofil innerhalb eines rechteckigen Nutz-Querschnitts, können zumindest einige der Spiegel der Strahlformungs-Spiegelgruppen 27 und/oder 28 mit einem Freiformprofil versehen sein, also als Reflexionsfläche eine Freiformfläche aufweisen. Ein Freiformprofil ist ein Höhenprofil, welches nicht als Kegelschnitt darstellbar ist. Unter Kegelschnitt sei hier auch eine Oberflächenform verstanden, die in zwei orthogonalen Richtungen durch einen unterschiedlichen Kegelschnitt beschrieben wird; ein Beispiel für eine solche Oberflächenform ist ein Zylinder. Ein Freiformprofil ist auch durch einen solchen Kegelschnitt nicht beschreibbar. Die Abweichung des Höhenprofils eines oder mehrerer Spiegel der Strahlformungsoptik 6 kann mehr als 1 Mikrometer ($\mu$m) betragen, insbesondere mehr als 5 Mikrometer und insbesondere mehr als 20 Mikrometer.

Die Spiegelgruppe 28 mit den Spiegeln BS2 und BS3 ist insgesamt im Strahlengang nach dem ersten Spiegel BS1 der weiteren Spiegelgruppe 27 und vor dem zweiten und letzten Spiegel BS4 dieser weiteren Spiegelgruppe 27 angeordnet.

Je nach Ausführung der Strahlformungsoptik 6 können die Einfallswinkel des Beleuchtungslichts 3 auf allen Spiegeln einer der Spiegelgruppen 27, 28 gleich groß sein oder können auf mindestens zwei Spiegeln einer der Spiegelgruppen 27, 28 verschieden groß sein. Unter Einfallswinkel wird in diesem Zusammenhang der Einfallswinkel eines Strahls, der zentral im EUV-Rohstrahl 4 verläuft, verstanden.

Der Spiegel BS1 ist als konvexer Zylinderspiegel ausgeführt, dessen Zylinderachse parallel zur x-Achse verläuft. Der Spiegel BS2 ist als konvexer Zylinderspiegel ausgeführt, dessen Zylinderachse parallel zur y-Achse verläuft. Der Spiegel BS3 ist als konkaver Zylinderspiegel ausgeführt, dessen Zylinderachse parallel zur y-Richtung verläuft. Der Spiegel BS4 ist als konkaver Zylinderspiegel ausgeführt, dessen Zylinderachse parallel x-Achse verläuft.

Die Spiegelgruppe 27 sorgt für eine Aufweitung eines Bündeldurchmessers des Rohstrahls in der x-Dimension um einen Faktor 2 im Vergleich zur aufweitenden Wirkung der Spiegelgruppe 28 in der y-Dimension. Ferner dienen die beiden Spiegelgruppen 27, 28 zur Formung der Rechteck-Querschnittskontur des EUV-Sammel-Ausgabestrahls 7.

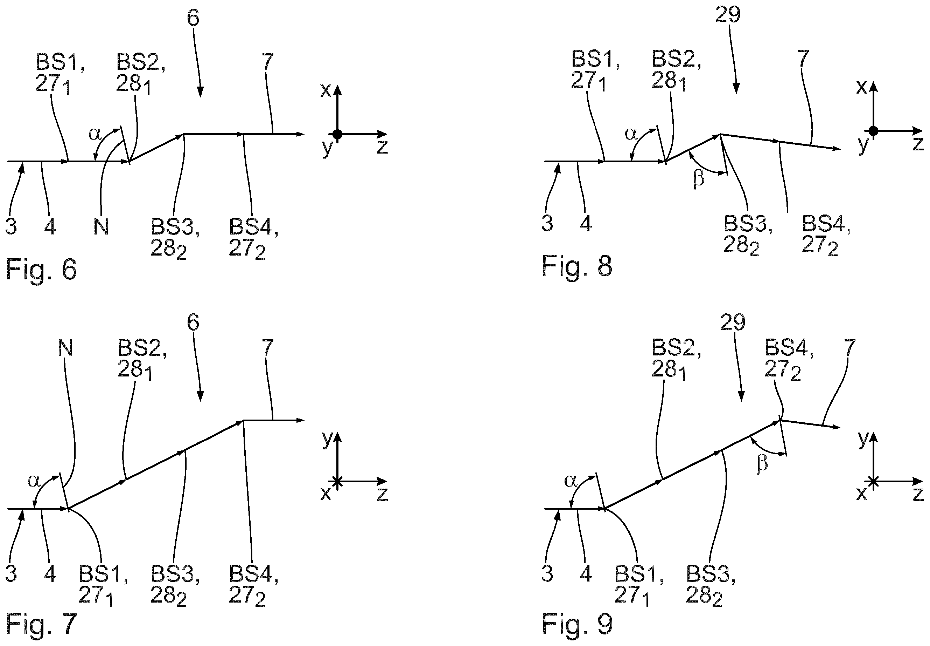

Fig. 6 bis 11 zeigen weitere Ausführungen der Strahlformungsoptik 6. Diese Ausführungen unterscheiden sich in der Abfolge der über die verschiedenen Strahlformungsspiegel BSi (i = 1, ...) erzeugten Umlenkwinkel. Es ist daher in den Fig. 6 bis 11 nur jeweils die Umlenkwirkung der Spiegel BSi dargestellt, ohne dass die Spiegel selbst körperlich angedeutet sind.

Die Ausführung der Strahlformungsoptik 6 nach den Fig. 6 und 7 entspricht hinsichtlich der Einfallswinkel des Beleuchtungslichts 3 auf den Spiegeln BS1 bis BS4 und auch hinsichtlich der Zuordnung der Spiegel BS1 bis BS4 zu den Spiegelgruppen 27, 28 der Ausführungen nach den Fig. 4 und 5. Die Einfallswinkel $\alpha$ des Beleuchtungslichts 3 an den Spiegelns BS1 bis BS4 ist für alle diese Spiegel bei der Ausführung nach den Fig. 6 und 7 identisch. Eine Haupt-Strahlrichtung des EUV-Sammel-Ausgabestrahls 7 ist damit identisch zur Haupt-Strahlrichtung des in die Strahlformungsoptik 6 einfallenden EUV-Rohstrahls 4.

Fig. 8 und 9 zeigen eine weitere Ausführung einer Strahlformungsoptik 29, die anstelle der Strahlformungsoptik 6 nach den Fig. 4 bis 7 zum Einsatz kommen kann. Komponenten und Funktionen, die denjenigen entsprechen, die vorstehend unter Bezugnahme auf die Strahlformungsoptik 6 bereits erläutert wurden, tragen bei der Strahlformungsoptik 29 die gleichen Bezugszeichen und werden nicht nochmals im Einzelnen diskutiert.

Im Unterschied zur Strahlformungsoptik 6 liegen bei der Strahlformungsoptik 29 verschiedene Einfallswinkel $\alpha, \beta$ der EUV-Strahlung auf den Spiegeln BS1 bis BS4 vor. Die Spiegel BS1 und BS2 reflektieren jeweils mit dem Einfallswinkel $\alpha$, sodass der Strahlengang der Strahlformungsoptik 29 bis zum dritten Spiegel BS3 mit dem Strahlengang in der Strahlformungsoptik 6 übereinstimmt. An den Spiegeln BS3 und BS4 wird das Beleuchtungslicht 3 mit einem im Vergleich zum Einfallwinkel $\alpha$ kleineren Einfallswinkel $\beta$, aber immer noch unter streifendem Einfall, reflektiert. Dies führt dazu, dass eine Haupt-Strahlrichtung des aus der Strahlformungsoptik 29 ausfallenden EUV-Sammel-Ausgabestrahls 7 nicht parallel zur z-Richtung verläuft, sondern sowohl in der xz-Ebene als auch in der yz-Ebene einen von Null verschiedenen Winkel zur Einfallsrichtung, die parallel zur z-Richtung verläuft, einschließt.

Die kleineren Einfallswinkel $\beta$ an den beiden letzten Spiegeln BS3 und BS4 der Strahlformungsoptik 29 ermöglichen eine baukleinere Ausführung dieser beiden letzten Spiegel BS3 und BS4, also eine Ausführung mit geringer ausgedehnter Reflexionsfläche. Dies spielt bei diesen beiden letzten Spiegeln BS3 und BS4 der Strahlformungsoptik 29 eine größere Rolle als bei den beiden führenden Spiegeln BS1 und BS2, da am Ort der letzten Spiegel BS3 und BS4 das Beleuchtungslicht bereits im Vergleich zum einfallenden EUV-Rohstrahl im Querschnitt deutlich aufgeweitet ist.

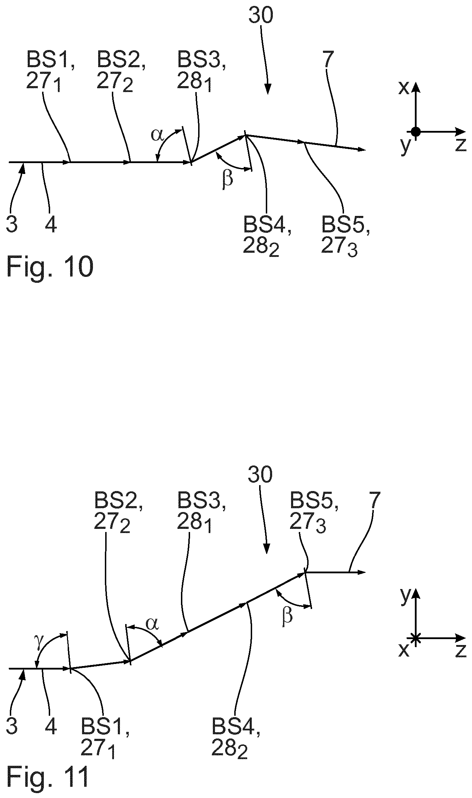

Fig. 10 und 11 zeigen eine weitere Ausführung einer Strahlformungsoptik 30, die anstelle der Strahlformungsoptiken 6, 29 zum Einsatz kommen kann. Komponenten und Funktionen, die denjenigen entsprechen, die vorstehend unter Bezugnahme auf die Strahlformungsoptiken 6, 29 bereits erläutert wurden, tragen bei der Strahlformungsoptik 30 die gleichen Bezugszeichen und werden nicht nochmals im Einzelnen diskutiert.

Die Strahlformungsoptik 30 hat insgesamt fünf Strahlformungsspiegel BS1, BS2, BS3, BS4, BS5, die wiederum in der Reihenfolge ihrer Beaufschlagung mit dem Beleuchtungslicht 3 innerhalb der Strahlformungsoptik 30 durchnummeriert sind. Die Spiegel BS1, BS2 und BS5 gehören zur ersten Spiegelgruppe 27 der Strahlformungsoptik 30 mit yz-Einfallsebene. Die beiden verbleibenden Spiegel BS3 und BS4 gehören zur Spiegelgruppe 28 mit xz-Einfallsebene.

Nach Reflexion am ersten Spiegel BS1 entspricht der Strahlengang des Beleuchtungslichts 3 in der Strahlformungsoptik 30 demjenigen in der Strahlformungsoptik 29, wobei dann die Spiegel BS2 bis BS5 der Strahlformungsoptik 30 die Funktion der Spiegel BS1 bis BS4 der Strahlformungsoptik 29 haben.

Der erste BS1 der Strahlformungsoptik 30 wird vom Beleuchtungslicht 3, also vom EUV-Rohstrahl 4, unter einem sehr streifenden Einfall beaufschlagt. Ein Einfallswinkel $\gamma$ des Beleuchtungslichts 3 auf dem ersten Spiegel BS1 der Strahlformungsoptik 30 ist also größer als der Einfallswinkel $\alpha$. Der Einfallswinkel $\gamma$ ist so groß, dass er einen Strahlrichtungsunterschied des Beleuchtungslichts 3, den das Beleuchtungslicht 3 zwischen den Spiegeln BS1 und BS2 einerseits und nach dem Spiegel BS5 andererseits in der yz-Ebene aufweist, genau kompensiert, sodass eine Haupt-Strahlrichtung des Beleuchtungslichts 3 in der yz-Ebene nach Austritt aus der Strahlformungsoptik 30 parallel zur Haupt-Strahlrichtung in der yz-Ebene beim Eintritt in die Strahlformungsoptik 30, nämlich parallel zur z-Richtung, ist.

Vor und nach der Strahlformungsoptik 30 verläuft das Beleuchtungslicht 3 parallel zu den Gebäudedecken des Gebäudes, in dem das System untergebracht ist.

Projiziert auf die Gruppen-Einfallsebene yz der Spiegelgruppe 27 der Strahlformungsoptik 30, in der die einzelnen Spiegel $27_1$ (BS1), 27, (BS2) und $27_3$ (BS5) unterschiedliche Einfallswinkel, nämlich $\gamma, \alpha$ und $\beta$ haben, verläuft

der mit der Strahlformungsoptik 30 erzeugte EUV-Sammel-Ausgabestrahl 7 in der gleichen Richtung, nämlich in der z-Richtung, wie der EUV-Rohstrahl 4, der in die Strahlformungsoptik 30 einfällt.

Eine typische Querschnittsdimension von Reflexionsflächen des letzten Spiegels BS4 bzw. BS5 der Strahlformungsoptik 6 bzw. 30 ist 1m bis 1,5m, wobei diese Spiegel typischerweise eine in erster Näherung rechteckförmige Reflexionsfläche besitzen und die angegebene Querschnittsdimension sich auf die längere der beiden Achsen bezieht. Eine typische Querschnittsdimension von Reflexionsflächen des ersten Spiegels BS1 der Strahlformungsoptik beträgt 20 mm bis 100 mm.

Nach Verlassen der Strahlformungsoptik 6 bzw. 30 verlaufen die Strahlen des EUV-Sammel-Ausgabestrahls 7 im Wesentlichen parallel. Die Divergenz des EUV-Sammel-Ausgabestrahls 7 kann kleiner als 10 mrad sein, insbesondere kleiner als 1 mrad, insbesondere kleiner als 100 μrad und insbesondere kleiner als 10 μrad.

Fig. 2 und 12 zeigen Beispiele für die Auskoppeloptik 8 zur Erzeugung der EUV-Einzel-Ausgabestrahlen 9 aus dem EUV-Sammel-Ausgabestrahl 7. Die Auskoppeloptik hat eine Mehrzahl von Auskoppelspiegeln $31_1$, $31_2$, ..., die den EUV-Einzel-Ausgabestrahlen $9_1$, $9_2$, ... zugeordnet sind und diese aus dem EUV-Sammel-Ausgabestrahl 7 auskoppeln. Fig. 2 zeigt eine Anordnung der Auskoppelspiegel 31 derart, dass das Beleuchtungslicht 3 bei der Auskopplung um 90° mit den Auskoppelspiegeln 31 umgelenkt wird. Bevorzugt ist eine Ausführung, bei der die Auskoppelspiegel 31 unter streifendem Einfall des Beleuchtungslichts 3 betrieben werden, wie schematisch in der Fig. 12 gezeigt. Ein Einfallswinkel α des Beleuchtungslichts 3 auf den Auskoppelspiegeln 31 ist bei der Ausführung nach Fig. 2 etwa 70°, kann aber auch noch deutlich darüber liegen und beispielsweise im Bereich von 85° liegen, sodass eine effektive Umlenkung des EUV-Einzel-Ausgabestrahls 9 durch den jeweiligen Auskoppelspiegel 31 im Vergleich zur Einfallsrichtung des EUV-Sammel-Ausgabestrahls 7 bei 10° liegt.

Jeder der Auskoppelspiegel $31_i$ ist an einen nicht näher dargestellten Kühlkörper thermisch angekoppelt.

Fig. 2 zeigt eine Auskoppeloptik 8 mit insgesamt vier Auskoppelspiegeln $31_1$ bis $31_4$. Fig. 12 zeigt eine Variante der Auskoppeloptik 8 mit insgesamt drei Auskoppelspiegeln $31_1$ bis $31_3$. Auch eine andere Anzahl N der Auskoppelspiegel 31 ist möglich, je nach der Anzahl N der mit der Lichtquelle 2 zu versorgenden Projektionsbelichtungsanlagen 1, beispielsweise N = 2 oder N ≥ 4, insbesondere N ≥ 8.

Nach der Auskopplung hat jeder der EUV-Einzel-Ausgabestrahlen 9 ein x/y-Aspektverhältnis von $1/\sqrt{N} : 1$. In der zweiten Querschnittsdarstellung von rechts in der Fig. 3 ist einer der EUV-Einzel-Ausgabestrahlen 9 mit diesem Aspektverhältnis dargestellt. Für den Fall N = 4 beträgt das x/y-Aspektverhältnis also 1:2. Auch dieser Aspektverhältnisbeitrag kann noch mit dem gewünschten Soll-Aspektverhältnis multipliziert werden.

Die Auskoppelspiegel $31_i$ (i = 1, 2, ...) sind im Strahlengang des EUV-Sammel-Ausgabestrahls 7 versetzt hintereinander so in Strahlrichtung des EUV-Sammel-Ausgabestrahls 7 angeordnet, dass der jeweils nächste Auskoppelspiegel $31_i$ einen randseitigen Querschnittsanteil des EUV-Sammel-Ausgabestrahls 7 reflektiert und dadurch diesen Querschnittsanteil als EUV-Einzel-Ausgabestrahl $9_i$ aus dem verbleibenden und an diesem Auskoppelspiegel $31_i$ vorbeifliegenden EUV-Sammel-Ausgabestrahl 7 auskoppelt. Dieses Auskoppeln vom Rand her wiederholt sich durch die folgenden Auskoppelspiegel $31_{i+1}$, ..., bis der letzte noch verbleibende Querschnittsanteil des EUV-Sammel-Ausgabestrahls 7 ausgekoppelt ist.

Im Querschnitt des EUV-Sammel-Ausgabestrahls 7 erfolgt eine Trennung zwischen den den EUV-Einzel-Ausgabestrahlen $9_i$ zugeordneten Querschnittsanteilen längs Trennlinien 32, die parallel zur y-Achse, also parallel zur kürzeren Seite des x/y-Rechteckquerschnitts des EUV-Sammel-Ausgabestrahls 7 verlaufen. Die Trennung der EUV-Einzel-Ausgabestrahlen $9_i$ kann derart erfolgen, dass jeweils der Querschnittsanteil, der am weitesten von der im Strahlengang nächstfolgenden optischen Komponente entfernt ist, abgeschnitten wird. Dieses erleichtert unter anderem die Kühlung der Auskoppeloptik 8.

Die der Auskoppeloptik 8 im Strahlengang des Beleuchtungslichts 3 nachfolgende Umlenkoptik 13 dient einerseits zum Umlenken der EUV-Einzel-Ausgabestrahlen 9 so, dass diese nach der Umlenkoptik 13 jeweils eine vertikale Strahlrichtung haben, und andererseits zur Anpassung des x/y-Aspektverhältnisses der EUV-Einzel-Ausgabestrahlen 9 auf ein x/y-Aspektverhältnis von 1:1, wie in der Fig. 3 ganz rechts dargestellt. Auch dieser Aspektverhältnisbeitrag kann noch mit dem gewünschten Soll-Aspektverhältnis multipliziert werden. Bei den vorstehenden x/y-Aspektverhältnissen, handelt es sich also um Aspektverhältnisbeiträge, die, multipliziert mit einem Soll-Aspektverhältnis, zum Beispiel dem Aspektverhältnis eines rechteckigen oder bogenförmigen Objektfeldes, ein gewünschtes Ist-Aspektverhältnis ergeben. Es kann sich bei den vorstehenden x/y-Soll-Aspektverhältnissen um das Aspektverhältnis eines ersten optischen Elements einer Beleuchtungsoptik 15 handeln. Es kann sich bei den vorstehenden x/y-Soll-Aspektverhältnissen um das Aspektverhältnis der Winkel des Beleuchtungslichts 3 an einem Zwischenfokus 42 einer Beleuchtungsoptik 15 handeln.

Für den Fall, dass nach der Auskoppeloptik 8 bereits ein vertikaler Strahlengang der EUV-Einzel-Ausgabestrahlen 9 vorliegt, kann auf eine umlenkende Wirkung der Umlenkoptik 13 verzichtet werden und es genügt die Anpassungswirkung in Bezug auf das x/y-Aspektverhältnis der EUV-Einzel-Ausgabestrahlen 9.

Die EUV-Einzel-Ausgabestrahlen 9 können hinter der Umlenkoptik 13 derart verlaufen, dass sie, gegebenenfalls nach Durchlaufen einer Fokussier-Baugruppe 14, unter einem Winkel in die Beleuchtungsoptik 15 treffen, wobei dieser Winkel eine effiziente Faltung der Beleuchtungsoptik erlaubt. Hinter der Umlenkoptik 13 kann der EUV-Einzel-Ausgabestrahl $9_i$ in einem Winkel von 0° bis 10° zur Senkrechten, in einem Winkel von 10° bis 20° zur Senkrechten, oder in einem Winkel von 20° bis 30° zur Senkrechten verlaufen.

Anhand der Fig. 13 bis 19 werden nachfolgend verschiedene Varianten für die Umlenkoptik 13 beschrieben. Das Beleuchtungslicht 3 wird dabei schematisch als ein einziger Strahl dargestellt, es wird also auf eine Bündeldarstellung verzichtet.

Die Divergenz des EUV-Einzel-Ausgabestrahls $9_i$ nach Durchlaufen der Umlenkoptik ist kleiner als 10 mrad, insbesondere kleiner als 1 mrad und insbesondere kleiner als 100 $\mu$rad, d.h., der Winkel zwischen zwei beliebigen Strahlen im Strahlenbündel des EUV-Einzel-Ausgabestrahls $9_i$ ist kleiner als 20 mrad, insbesondere kleiner als 2 mrad und insbesondere kleiner als 200 $\mu$rad. Dies ist für die im folgenden beschriebenen Varianten erfüllt.

Die Umlenkoptik 13 nach Fig. 13 lenkt den ausgekoppelten EUV-Einzel-Ausgabestrahl 9 insgesamt um einen Umlenkwinkel von etwa 75° ab. Der EUV-Einzel-Ausgabestrahl 9 fällt auf die Umlenkoptik 13 nach Fig. 13 also unter einem Winkel von etwa 15° zur Horizontalen (xy-Ebene) ein und verlässt die Umlenkoptik 13 mit einer Strahlrichtung parallel zur x-Achse in der Fig. 13. Die Umlenkoptik 13 hat eine Gesamttransmission für den EUV-Einzel-Ausgabestrahl 9 von etwa 55 %.

Die Umlenkoptik 13 nach Fig. 13 hat insgesamt sechs Umlenkspiegel D1, D2, D3, D4, D5 und D6, die in der Reihenfolge ihrer Beaufschlagung im Strahlengang des Beleuchtungslichts 3 durchnummeriert sind. Von den Umlenkspiegeln D1 bis D6 ist schematisch jeweils nur ein Schnitt durch deren Reflexionsfläche dargestellt, wobei eine Krümmung der jeweiligen Reflexionsfläche stark übertrieben dargestellt ist. Alle Spiegel D1 bis D6 der Umlenkoptik 13 nach Fig. 13 werden unter streifendem Einfall mit dem Beleuchtungslicht 3 in einer gemeinsamen Umlenk-Einfallsebene parallel zur xz-Ebene beaufschlagt.

Die Spiegel D1 und D2 sind als konvexe Zylinderspiegel mit Zylinderachse parallel zur y-Achse ausgeführt. Der Spiegel D3 ist als Planspiegel ausgeführt. Die Spiegel D4 bis D6 sind als konkave Zylinderspiegel wiederum mit Zylinderachse parallel zur y-Achse ausgeführt.

Die konvexen Zylinderspiegel werden auch als domförmige Spiegel bezeichnet. Die konkaven Zylinderspiegel werden auch als schüsselförmige Spiegel bezeichnet.

Die kombinierte bündelformende Wirkung der Spiegel D1 bis D6 ist so, dass das x/y-Aspektverhältnis vom Wert

$$1/\sqrt{N} : 1$$

auf den Wert 1:1 angepasst wird. In der x-Dimension erfolgt also im Verhältnis eine Streckung des Bündelquerschnitts um den Faktor $\sqrt{N}$.

Mindestens einer der Umlenkspiegel D1 bis D6 oder auch alle Umlenkspiegel D1 bis D6 können über zugeordnete Aktoren 34 in der x-Richtung und/oder in der z-Richtung verlagerbar ausgeführt sein. Hierdurch kann eine Anpassung einerseits der Umlenkwirkung und andererseits der Aspektverhältnis-Anpassungswirkung der Umlenkoptik 13 herbeigeführt werden. Alternativ oder zusätzlich kann mindestens einer der Umlenkspiegel D1 bis D6 als hinsichtlich seines Krümmungsradius anpassbarer Spiegel ausgeführt sein. Hierzu kann der jeweilige Spiegel D1 bis D6 aus einer Mehrzahl von Einzelspiegeln aufgebaut sein, die aktorisch zueinander verlagerbar sind, was in der Zeichnung nicht dargestellt ist.

Die verschiedenen optischen Baugruppen des Systems mit den Projektionsbelichtungsanlagen 1 können adaptiv ausgeführt sein. Es kann also zentral vorgegeben werden, wie viele der Projektionsbelichtungsanlagen 1 mit welchem energetischen Verhältnis mit EUV-Einzel-Ausgabestrahlen $9_i$ von der Lichtquelle 2 versorgt werden sollen und welche Bündelgeometrie bei jeweiligen EUV-Einzel-Ausgabestrahl 9 nach Durchlaufen der jeweiligen Umlenkoptik 13 vorliegen soll. Je nach Vorgabewerten können sich die EUV-Einzel-Ausgabestrahlen $9_i$ in ihrer Intensität und auch in ihrem Soll-x/y-Aspektverhältnis unterscheiden. Insbesondere ist es möglich, durch adaptive Einstellung der Auskoppelspiegel $31_i$ die energetischen Verhältnisse der EUV-Einzel-Ausgabestrahlen $9_i$ zu verändern, und durch adaptive Einstellung der Umlenkoptik 13 die Größe und das Aspektverhältnis des EUV-Einzel-Ausgabestrahls $9_i$ nach Durchlaufen der Umlenkoptik 13 unverändert zu halten.

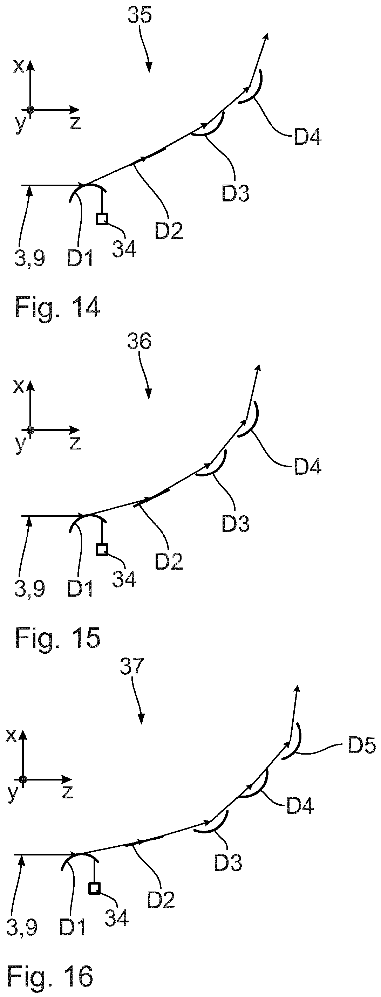

Anhand der Fig. 14 bis 19 werden nachfolgend weitere Ausführungen von Umlenkoptiken beschrieben, die anstelle der Umlenkoptik 13 nach Fig. 13 bei einem System mit N Projektionsbelichtungsanlagen 1 zum Einsatz kommen können. Komponenten und Funktionen, die vorstehend unter Bezugnahme auf die Fig. 1 bis 13 und insbesondere unter Bezugnahme auf die Fig. 13 bereits erläutert wurden, tragen die gleichen Bezugszeichen und werden nicht nochmals im Einzelnen diskutiert.

Eine Umlenkoptik 35 nach Fig. 14 hat insgesamt vier Spiegel D1, D2, D3, D4 im Strahlengang des Beleuchtungslichts 3. Der Spiegel D1 ist als konvexer Zylinderspiegel ausgeführt. Die Spiegel D2 bis D4 sind als konkave Zylinderspiegel ausgeführt.

Genauere optische Daten können der nachfolgenden Tabelle entnommen werden. Die erste Spalte bezeichnet hierbei den Krümmungsradius des jeweiligen Spiegels D1 bis D4 und die zweite Spalte den Abstand des jeweiligen Spiegels D1 bis D3 zum jeweils nachfolgenden Spiegel D2 bis D4. Der Abstand bezieht sich auf diejenige Distanz, die ein zentraler Strahl innerhalb des EUV-Einzel-Ausgabestrahls $9_i$ zwischen den entsprechenden Reflexionen zurücklegt. Die in dieser und den nachfolgenden Tabellen verwendete Einheit ist jeweils mm, soweit nichts anderes beschrieben ist. Der EUV-Einzel-Ausgabestrahl $9_i$ fällt hierbei mit einem Halbmesser $d_{in}/2$ von 10mm in die Umlenkoptik 13 ein.

Tabelle zu Fig. 14

|  | Krümmungsradius | Abstand zum nächsten Spiegel |
|---|---|---|
| D1 | 2922.955800 | 136.689360 |
| D2 | -49802.074797 | 244.501473 |
| D3 | -13652.672229 | 342.941568 |
| D4 | -22802.433560 |  |

Die Umlenkoptik 35 nach Fig. 14 weitet das x/y-Aspektverhältnis um einen Faktor 3 auf.

Fig. 15 zeigt eine weitere Ausführung einer Umlenkoptik 36 ebenfalls mit vier Spiegeln D1 bis D4. Der Spiegel D1 ist ein konvexer Zylinderspiegel. Der Spiegel D2 ist ein Planspiegel. Die Spiegel D3 und D4 sind zwei Zylinderspiegel mit identischem Krümmungsradius.

Genauere Daten können der nachfolgenden Tabelle entnommen werden, die vom Aufbau der Tabelle zur Fig. 14 entspricht.

Tabelle zu Fig. 15

|  | Krümmungsradius | Abstand zum nächsten Spiegel |
|---|---|---|
| D1 | 5080.620899 | 130.543311 |
| D2 | 0.000000 | 187.140820 |
| D3 | -18949.299940 | 226.054877 |
| D4 | -18949.299940 |  |

Die Umlenkoptik 36 nach Fig. 15 weitet das x/y-Aspektverhältnis des EUV-Einzel-Ausgabestrahls 9 um einen Faktor 2 auf.

Fig. 16 zeigt eine weitere Ausführung einer Umlenkoptik 37 mit fünf Spiegeln D1 bis D5. Der erste Spiegel D1 ist ein konvexer Zylinderspiegel. Der zweite Spiegel D2 ist ein Planspiegel. Die weiteren Spiegel D3 bis D5 sind drei konkave Zylinderspiegel.

Genauere Daten können der nachfolgenden Tabelle entnommen werden, die vom Aufbau den Tabellen zu Fig. 14 und 15 entspricht.

Tabelle zu Fig. 16

|  | Krümmungsradius | Abstand zum nächsten Spiegel |
|---|---|---|
| D1 | 3711.660251 | 172.323866 |
| D2 | 0.000000 | 352.407636 |
| D3 | -27795.782391 | 591.719804 |
| D4 | -41999.478002 | 717.778100 |
| D5 | -101011.739006 |  |

Die Umlenkoptik 37 nach Fig. 16 weitet das x/y-Aspektverhältnis des EUV-Einzel-Ausgabestrahls 9 um einen Faktor 5 auf.

Eine weitere Ausführung der Umlenkoptik 37 unterscheidet sich von der Ausführung nach Fig. 16 nur durch die Krümmungsradien und die Spiegelabstände, die in der nachfolgenden Tabelle angegeben sind:

Tabelle "Alternativdesign zu Fig. 16"

|    | Krümmungsradius | Abstand zum nächsten Spiegel |
|----|-----------------|------------------------------|
| D1 | 4283.491081     | 169.288384                   |
| D2 | 0.000000        | 318.152124                   |
| D3 | -26270.138665   | 486.408438                   |
| D4 | -41425.305704   | 572.928893                   |
| D5 | -91162.344644   |                              |

Im Unterschied zur ersten Ausführung nach Fig. 16 hat dieses Alternativdesign einen Aufweitfaktor von 4 für das x/y-Aspektverhältnis.

Noch eine weitere Ausführung der Umlenkoptik 37 unterscheidet sich von der Ausführung nach Fig. 16 durch die Krümmungsradien und die Spiegelabstände, die in der nachfolgenden Tabelle angegeben sind:

Tabelle "weiteres Alternativdesign" zu Fig. 16

|    | Krümmungsradius | Abstand zum nächsten Spiegel |
|----|-----------------|------------------------------|
| D1 | 5645.378471     | 164.790501                   |
| D2 | 0.000000        | 269.757678                   |
| D3 | -28771.210382   | 361.997270                   |
| D4 | -55107.732703   | 424.013033                   |
| D5 | -55107.732703   |                              |

Im Unterschied zur vorstehend beschriebenen Ausführungsform hat dieses weitere Alternativdesign einen Aufweitfaktor von 3 für das x/y-Aspektverhältnis. Die Krümmungsradien der beiden letzten Spiegel D4 und D5 sind identisch.

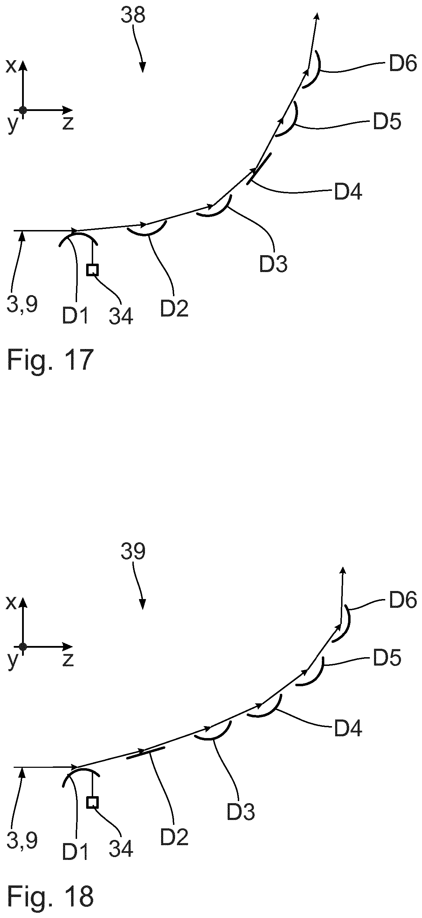

Fig. 17 zeigt eine weitere Ausführung einer Umlenkoptik 38 mit sechs Spiegeln D1 bis D6. Der erste Spiegel D1 ist ein konvexer Zylinderspiegel. Die beiden nächsten Umlenkspiegel D2, D3 sind jeweils konkave Zylinderspiegel mit identischem Krümmungsradius. Der nächste Umlenkspiegel D4 ist ein Planspiegel. Die beiden letzten Umlenkspiegel D5, D6 der Umlenkoptik 38 sind wiederum konkave Zylinderspiegel mit identischem Krümmungsradius.

Genauere Daten können der nachfolgenden Tabelle entnommen werden, die vom Aufbau der Tabelle zu Fig. 16 entspricht.

Tabelle zu Fig. 17

|    | Krümmungsradius | Abstand zum nächsten Spiegel |
|----|-----------------|------------------------------|
| D1 | 7402.070457     | 197.715713                   |
| D2 | -123031.042588  | 332.795789                   |
| D3 | -123031.042588  | 459.491141                   |
| D4 | 0.000000        | 608.342998                   |
| D5 | -87249.129389   | 857.423893                   |
| D6 | -87249.129389   |                              |

Die Umlenkoptik 38 hat einen Aufweitfaktor von 5 für das x/y-Aspektverhältnis.

Fig. 18 zeigt eine weitere Ausführung einer Umlenkoptik 39 mit sechs Spiegeln D1 bis D6. Der erste Spiegel D1 der Umlenkoptik 39 ist ein konvexer Zylinderspiegel. Der nachfolgende zweite Umlenkspiegel D2 ist ein Planspiegel. Die nachfolgenden Umlenkspiegel D3 bis D6 sind jeweils konkave Zylinderspiegel. Die Krümmungsradien der Spiegel D3 und D4 einerseits sowie der Spiegel D5 und D6 andererseits sind identisch.

Genauere Daten können der nachfolgenden Tabelle entnommen werden, die vom Aufbau der Tabelle zu Fig. 17 entspricht.

Tabelle zu Fig. 18

|  | Krümmungsradius | Abstand zum nächsten Spiegel |
|---|---|---|
| D1 | 7950.882348 | 196.142128 |
| D2 | 0.000000 | 322.719989 |
| D3 | -207459.983757 | 451.327919 |
| D4 | -207459.983757 | 627.317787 |
| D5 | -90430.481262 | 839.555523 |
| D6 | -90430.481262 | |

Die Umlenkoptik 39 hat einen Aufweitfaktor von 5 für das x/y-Aspektverhältnis.

Bei einem Alternativdesign zu Fig. 18 ist die Spiegelabfolge konvex/plan/konkav/konkav/konkav/konkav genau wie bei der vorstehend beschriebenen Ausführung der Umlenkoptik 39. Dieses Alternativdesign zu Fig. 18 unterscheidet sich in den konkreten Krümmungsradien und Spiegelabständen, wie die nachfolgende Tabelle verdeutlicht:

Tabelle "Alternativdesign zu Fig. 18"

|  | Krümmungsradius | Abstand zum nächsten Spiegel |
|---|---|---|
| D1 | 10293.907897 S | 192.462359 |
| D2 | 0.000000 S | 285.944981 |
| D3 | -101659.408806 S | 360.860262 |
| D4 | -101659.408806 S | 451.967976 |
| D5 | -101659.408806 S | 517.093086 |
| D6 | -101659.408806 | |

Dieses Alternativdesign zu Fig. 18 hat einen Aufweitfaktor von 4 für das x/y-Aspektverhältnis des EUV-Einzel-Ausgabestrahls 9.

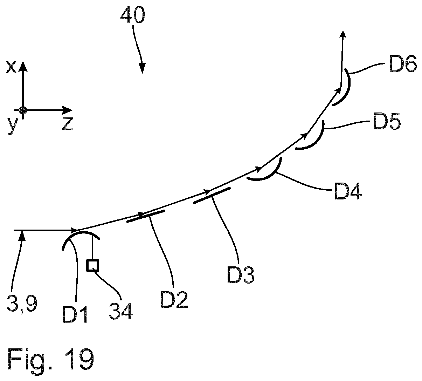

Fig. 19 zeigt eine weitere Ausführung einer Umlenkoptik 40 mit sechs Spiegeln D1 bis D6. Der erste Umlenkspiegel D1 der Umlenkoptik 40 ist ein konvexer Zylinderspiegel. Die beiden nachfolgenden Umlenkspiegel D2 und D3 sind Planspiegel. Die nachfolgenden Umlenkspiegel D4 bis D6 der Umlenkoptik 40 sind konkave Zylinderspiegel. Die Krümmungsradien der beiden letzten Umlenkspiegel D5 und D6 sind identisch.

Genauere Daten können der nachfolgenden Tabelle entnommen werden, die vom Aufbau der Tabelle zu Fig. 18 entspricht.

Tabelle zu Fig. 19

|  | Krümmungsradius | Abstand zum nächsten Spiegel |
|---|---|---|
| D1 | 8304.649871 | 195.440359 |
| D2 | 0.000000 | 314.991402 |
| D3 | 0.000000 | 435.995630 |
| D4 | -237176.552267 | 622.135962 |
| D5 | -85355.457233 | 852.531832 |
| D6 | -85355.457233 | |

Die Umlenkoptik 40 hat einen Aufweitfaktor von 5 für das x/y-Aspektverhältnis.

Bei einer weiteren, nicht dargestellten Variante hat die Umlenkoptik insgesamt acht Spiegel D1 bis D8. Die im Strahlengang des EUV-Einzel-Ausgabestrahls 9 führenden beiden Umlenkspiegel D1 und D2 sind konkave Zylinderspiegel. Die vier nachfolgenden Umlenkspiegel D3 bis D6 sind konvexe Zylinderspiegel. Die beiden letzten Umlenkspiegel D7 und D8 dieser Umlenkoptik sind wiederum konkave Zylinderspiegel.

Diese Spiegel D1 bis D8 sind vergleichbar zum Spiegel D1 der Fig. 13 mit Aktoren 34 verbunden, über die ein Abstand zwischen benachbarten Spiegeln D1 bis D8 vorgegeben werden kann.

Die nachfolgende Tabelle zeigt die Auslegung dieser Umlenkoptik mit den acht Spiegeln D1 bis D8, wobei neben den Krümmungsradien auch die Spiegelabstände für verschiedenen Halbmesser $d_{out}/2$ des ausfallenden EUV-Einzel-Ausgabestrahls $9_i$ angeben sind. Der EUV-Einzel-Ausgabestrahl fällt hierbei mit einer Halbmesser $d_{in}/2$ von 10mm in die Umlenkoptik mit acht Spiegeln D1 bis D8 ein, sodass je nach den angegebenen Abstandswerten Aufweitfaktoren für das x/y-Aspektverhältnis des umgelenkten EUV-Einzel-Ausgabestrahls $9_i$ von 4,0, von 4,5 und von 5,0 realisiert werden.

| | Krüummungsradius [mm] | 40 mm Halbmesser | Abstände [mm] für 45 mm Halbmesser | 50 mm Halbmesser |
|---|---|---|---|---|
| D1 | -24933.160828 | 233.314949 | 313.511608 | 355.515662 |
| D2 | -96792.387128 | 261.446908 | 184.453510 | 159.189884 |
| D3 | 13933.786194 | 120.747224 | 278.984993 | 124.048048 |
| D4 | 7248.275614 | 150.818354 | 311.248621 | 385.643707 |
| D5 | 29532.874950 | 204.373669 | 219.654058 | 296.180993 |
| D6 | 100989.002210 | 872.703663 | 698.841397 | 665.602749 |
| D7 | -87933.616578 | 1176.395997 | 1462.002885 | 1318.044212 |
| D8 | -79447.352117 | | | |

Bei einer weiteren, ebenfalls nicht dargestellten Ausführung der Umlenkoptik sind vier Spiegel D1 bis D4 vorhanden. Der erste Spiegel D1 und der dritte Spiegel D3 im Strahlengang des EUV-Einzel-Ausgabestrahls $9_i$ sind als konvexe Zylinderspiegel und die beiden weiteren Spiegel D2 und D4 sind als konkave Zylinderspiegel ausgeführt. In der nachfolgenden Tabelle sind neben den Krümmungsradien auch Abstandswerte angeben, die für einen Eingangs-Halbmesser $d_{in}/2$ des EUV-Einzel-Ausgabestrahls $9_i$ von 10mm gerechnet sind, die also zu Aufweitfaktoren beim Durchgang durch diese Umlenkgruppe mit den vier Spiegeln D1 bis D4 für das x/y-Aspektverhältnis von 1,5, (Halbmesser $d_{out}/2$ 15mm) von 1,75 (Halbmesser $d_{out}/2$ 17,5mm) und von 2,0 (Halbmesser $d_{out}/2$ 20mm) führen.

| | Krümmungsradius [mm] | 15 mm Halbmesser | Abstände [mm] für 17,5 mm Halbmesser | 20 mm Halbmesser |
|---|---|---|---|---|
| D1 | 112692.464497 | 1718.226630 | 6884.616863 | 7163.537958 |
| D2 | -488601.898900 | 250.044362 | 205.433074 | 3185.838011 |
| D3 | 112362.082498 | 1439.444519 | 263.976778 | 175.458248 |
| D4 | -86905.078626 | | | |

Die Umlenkoptik 13 kann derart ausgelegt sein, dass parallel einfallendes Licht die Umlenkoptik parallel wieder verlässt. Die Abweichung der Richtungen parallel in die Umlenkoptik 13 eingefallener Strahlen des EUV-Einzel-Ausgabestrahls $9_i$ nach Verlassen der Umlenkoptik kann kleiner als 10 mrad, insbesondere kleiner als 1 mrad und insbesondere kleiner als 100 $\mu$rad sein.

Die Spiegel Di der Umlenkoptik 13 können auch ohne Brechkraft, also plan, ausgeführt sein. Dies ist insbesondere möglich, wenn das x/y-Aspektverhältnis eines EUV-Sammel-Ausgabestrahls 7 ein Seitenverhältnis von N : 1 besitzt, wobei N eine Anzahl der mit der Lichtquelle 2 zu versorgenden Projektionsbelichtungsanlagen 1 ist. Das Aspektverhältnis kann noch mit einem gewünschten Soll-Aspektverhältnis multipliziert werden.

Eine Umlenkoptik 13 aus Spiegeln Di ohne Brechkraft kann aus drei bis zehn Spiegeln bestehen, insbesondere aus vier bis acht Spiegeln, insbesondere aus vier oder fünf Spiegeln.

Die Lichtquelle 2 kann linear polarisiertes Licht abgegeben, die Polarisationsrichtung, d.h., die Richtung des elektrischen Feldstärkevektors, des Beleuchtungslichts 3 beim Auftritt auf einen Spiegel der Umlenkoptik 13 kann senkrecht auf der Einfallsebene stehen. Eine Umlenkoptik 13 aus Spiegeln Di ohne Brechkraft kann aus weniger als drei Spiegeln bestehen, insbesondere aus einem Spiegel.

In der Strahlführungsoptik 10 der jeweiligen Umlenkoptik im Strahlengang des jeweiligen EUV-Einzel-Ausgabestrahls 9 nachgelagert ist eine Fokussier-Baugruppe 41, die auch als Einkoppeloptik bezeichnet ist.

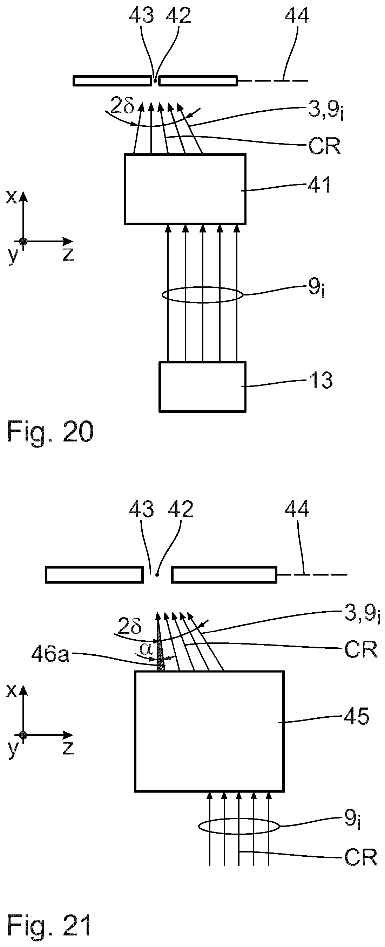

Fig. 20 zeigt schematisch die Funktion der Einkoppeloptik 41 für einen der EUV-Einzel-Ausgabestrahlen $9_i$. Die Fokussier-Baugruppe 41 überführt den jeweiligen EUV-Einzel-Ausgabestrahl $9_i$ in einen Zwischenfokus 42 der Strahlführungsoptik 10. Der Zwischenfokus 42 ist am Ort einer Durchtrittsöffnung 43 für das Beleuchtungslicht 3 angeordnet.

Die Durchtrittsöffnung 43 kann in einer Gebäudedecke eines Gebäudes ausgeführt sein, in dem das System mit den Projektionsbelichtungsanlagen 1 untergebracht ist. Die Gebäudedecke verläuft in einer Zwischenfokusebene 44 der Strahlführungsoptik 10, die auch in der Fig. 1 dargestellt ist.

Die Fokussier-Baugruppe 41 hat einen effektiven Umlenkwinkel für einen zentralen Hauptstrahl CR von etwa 10°.

In einer anderen Ausgestaltung hat die Fokussier-Baugruppe 41 einen effektiven Umlenkwinkel für einen zentralen Hauptstrahl CR, wobei der effektive Umlenkwinkel zwischen $\delta/2$ und $\delta$ liegt, und $\delta$ der Winkel im Zwischenfokus 42 zwischen einem zentralen Hauptstrahl und einem Randstrahl ist. Der Sinus von $\delta$ wird auch als numerische Apertur (NA) der Strahlung 3 im Zwischenfokus 42 bezeichnet.

Fig. 21 verdeutlicht die fokussierende Wirkung einer alternativen Fokussier-Baugruppe 45, die anstelle der Fokussier-Baugruppe 41 nach Fig. 20 zum Einsatz kommen kann. Im Unterschied zur Fokussier-Baugruppe 41 lenkt die Fokussier-Baugruppe 45 alle Einzelstrahlen des einfallenden EUV-Einzel-Ausgabestrahls $9_i$ in der xz-Einfallsebene in der gleichen Ablenkrichtung, nämlich hin zu negativen y-Werten, ab. Der geringste Ablenkwinkel des in der Fig. 21 ganz links dargestellten, fokussierten Einzelstrahls 46 des EUV-Einzel-Ausgabestrahls $9_i$ ist in der Fig. 21 mit $\alpha$ bezeichnet und beträgt 5° oder weniger.

Die Fokussier-Baugruppe 45 hat einen effektiven Umlenkwinkel für den zentralen Hauptstrahl CR von etwa 20°.

In einer anderen Ausgestaltung hat die Fokussier-Baugruppe 45 einen effektiven Umlenkwinkel für einen zentralen Hauptstrahl CR, wobei der effektive Umlenkwinkel zwischen $\delta/2$ und $\delta$ liegt, und $\delta$ der Winkel im Zwischenfokus 42 zwischen einem zentralen Hauptstrahl und einem Randstrahl ist.

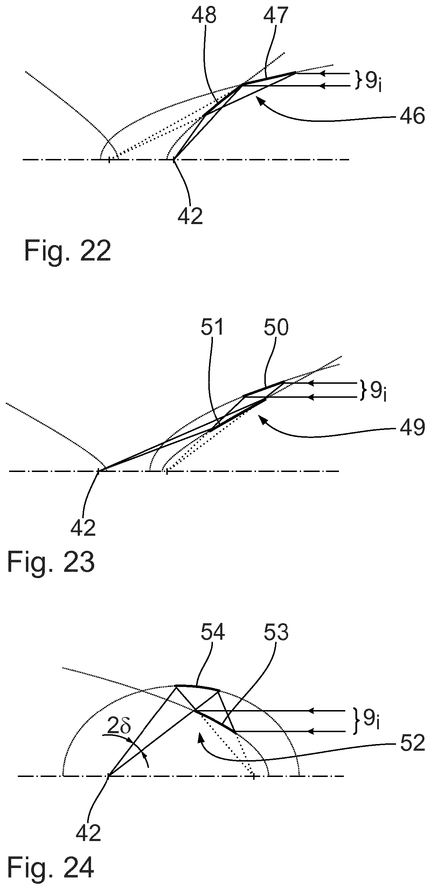

Anhand der Fig. 22 bis 25 werden nachfolgend Ausführungsvarianten für Fokussier-Baugruppen erläutert, die für die Fokussier-Baugruppen 41 oder 45 zum Einsatz kommen können.

Die Fig. 22 bis 25 stellen jeweils Meridionalschnitte durch die beteiligten Spiegel-Reflexionsflächen dar. Genutzte Reflexionsabschnitte dieser Spiegelflächen sind durch stärkere Linien hervorgehoben. Zur Verdeutlichung der Flächenkonstruktion Ellipsoid-Hyperboloid/Paraboloid sind für die jeweilige Spiegelform charakteristische Parent-Flächenschnitte mit dünneren Linien ebenfalls eingezeichnet.

Eine Fokussier-Baugruppe 46 nach Fig. 22 hat zwei im Strahlengang des jeweiligen EUV-Einzel-Ausgabestrahls $9_i$ nachgeordnete Spiegel, nämlich einen führenden Ellipsoid-Spiegel 47 und einen nachfolgenden Hyperboloid-Spiegel 48.

Ein effektiver Umlenkwinkel für den zentralen Hauptstrahl CR des EUV-Einzel-Ausgabestrahls $9_i$ beträgt bei der Fokussier-Baugruppe 46 etwa 50°. Bei der Fokussier-Baugruppe 46 addieren sich die Umlenkwinkel für den zentralen Hauptstrahl CR bei der Reflexion an den beiden Spiegeln 47 und 48.

Die Spiegel 47 und 48 sind als Konkavspiegel ausgeführt. Die Fokussier-Baugruppe 46 ist nach Art eines Wolter-Kollektors vom Typ I ausgeführt. Informationen zu den verschiedenen Typen von Wolter-Kollektoren finden sich in: H. Wolter, Spiegelsysteme streifenden Einfalls als abbildende Optiken für Röntgenstrahlen, Annalen der Physik, Band 10, Seiten 94 bis 114, 1952.

In einer alternativen Ausgestaltung ist ein effektiver Umlenkwinkel für den zentralen Hauptstrahl CR des EUV-Ausgabestrahls $9_i$ bei der Fokussier-Baugruppe 46 kleiner als 40°, insbesondere kleiner als 30°, insbesondere kleiner als 15°, und insbesondere kleiner als 10°.

In einer alternativen Ausgestaltung ist ein effektiver Umlenkwinkel für den zentralen Hauptstrahl CR des EUV-Ausgabestrahls $9_i$ bei der Fokussier-Baugruppe 46 kleiner als der doppelte Winkel zwischen dem zentralen Hauptstrahl CR und einem Randstrahl im Zwischenfokus 42.

Eine Fokussier-Baugruppe 49 nach Fig. 23 umfasst ebenfalls zwei Spiegel, nämlich einen führenden Ellipsoid-Spiegel 50 und einen nachfolgenden Hyperboloid-Spiegel 51.

Der Spiegel 50 ist konkav und der Spiegel 51 ist konvex.

Bei der Fokussier-Baugruppe 49 subtrahieren sich die Umlenkwinkel für den zentralen Hauptstrahl CR bei der Reflexion an den Spiegeln 50 und 51.

Ein effektiver Umlenkwinkel für den Hauptstrahl CR beträgt bei der Fokussier-Baugruppe 49 etwa 30°.

Die Fokussier-Baugruppe 49 ist nach Art eines Wolter-Kollektors vom Typ II ausgeführt.

In einer alternativen Ausgestaltung hat die Fokussier-Baugruppe 49 einen effektiven Umlenkwinkel für den Hauptstrahl CR von maximal 20°, insbesondere von maximal 15°, und insbesondere von maximal 10°.

In einer Ausgestaltung der Fokussier-Baugruppe 49 beträgt der effektive Umlenkwinkel für den Hauptstrahl CR weniger als der doppelte Winkel zwischen Hauptstrahl CR und einem Randstrahl im Zwischenfokus 42.

Eine Fokussier-Baugruppe 52 nach Fig. 24 hat ebenfalls zwei im Strahlengang des EUV-Einzel-Ausgabestrahls $9_i$ einander nachgeordnete Spiegel, nämlich einen führenden Paraboloid-Spiegel 53 und einen nachfolgenden Ellipsoid-Spiegel 54.

Der Spiegel 53 ist konvex und der Spiegel 54 ist konkav.

Bei der Fokussier-Baugruppe 52 subtrahieren sich die Umlenkwinkel für den zentralen Hauptstrahl CR bei der Reflexion an den Spiegeln 53 und 54.

Ein effektiver Umlenkwinkel für den Hauptstrahl CR beträgt bei der Fokussier-Baugruppe 52 etwa 50°.

Die Fokussier-Baugruppe 52 ist nach Art eines Wolter-Kollektors vom Typ III ausgeführt.

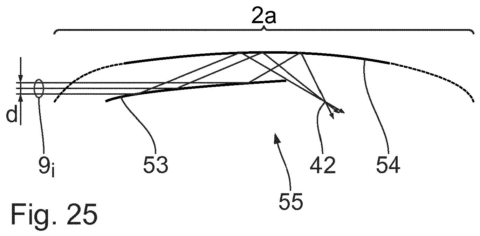

Fig. 25 zeigt eine weitere Ausführung einer Fokussier-Baugruppe 52, die ebenfalls nach Art eines Wolter-Kollektors des Typs III ausgeführt ist. Komponenten und Funktionen, die vorstehend unter Bezugnahme auf die Fokussier-Baugruppen nach den Fig. 21 bis 24 und insbesondere unter Bezugnahme auf die Fokussier-Baugruppe nach Fig. 24 bereits erläutert wurden, tragen die gleichen Bezugszeichen und werden nicht nochmals im Einzelnen diskutiert.

Eine Ausgangsdivergenz des EUV-Einzel-Ausgabestrahls $9_i$ wird vorgegeben durch einen numerische Apertur NA des EUV-Einzel-Ausgabestrahls $9_i$ im Zwischenfokus 42. Abhängig von dieser numerischen Apertur NA kann näherungsweise für eine Transmission T der Fokussier-Baugruppe nach Fig. 25 angegeben werden:

$$T = 1 - 0{,}9\text{NA}$$

Hierbei ist die numerische Apertur NA als der Sinus des Winkels zwischen einem Hauptstrahl und einem Randstrahl im Zwischenfokus 42 definiert. Eine äquivalente Definition lautet, dass die NA der Sinus des halben Bündel-Divergenzwinkels ist.

Eine große Halbachse eines Ellipsoids, welches die Reflexionsfläche des Ellipsoid-Spiegels 54 beschreibt, hat die Länge a. Ein Bauraum 2a, der für die Fokussier-Baugruppe 55 erforderlich ist, hat eine typische Dimension von 2a.

Die typische Bauraum-Dimension 2a beträgt etwa das fünfzigfache eines Strahldurchmessers d des EUV-Einzel-Ausgabestrahls $9_i$ beim Einfall in die Fokussier-Baugruppe 55. Dieses Verhältnis allenfalls schwach abhängig von der numerischen Apertur NA im Zwischenfokus 42.

Eine typische Dimension der Reflexionsflächen des Ellipsoid-Spiegels 54 beträgt ebenfalls a. Bei einer typischen Ausdehnung der Reflexionsfläche des Ellipsoid-Spiegels 54 von 1,4m folgt für den Strahldurchmesser d ein Durchmesser von etwa 60mm.

Der Ellipsoid-Spiegel 54 hat eine kurze Halbachse b. Diese kurze Halbachse b steht senkrecht auf der Zeichenebene der Fig. 25. Für das Verhältnis der Halbachsen b/a gilt:

$$b/a \sim 0{,}8\text{NA}$$

NA ist hierbei die numerische Apertur im Zwischenfokus 42.

Der Paraboloid-Spiegel 53 hat eine Brennweite f. Für das Verhältnis aus der langen Halbachse a des Ellipsoid-Spiegels 54 und der Brennweite f des Paraboloid-Spiegels gilt:

$$a/f > 50$$

Bei der Herstellung eines mikro- oder nanostrukturierten Bauteils mit der Projektionsbelichtungsanlage 1 werden zunächst das Retikel 12 und der Wafer 24 bereitgestellt. Anschließend wird eine Struktur auf dem Retikel 12 auf eine lichtempfindliche Schicht des Wafers 24 mit Hilfe der Projektionsbelichtungsanlage 1 projiziert. Durch Entwicklung der lichtempfindlichen Schicht wird eine Mikro- oder Nanostruktur auf dem Wafer 24 und somit das mikro- oder nanostrukturierte Bauteil hergestellt, beispielsweise ein Halbleiterbauelement in Form eines Speicherchips.

Im Folgenden werden weitere Aspekte der Projektionsbelichtungsanlage 1, insbesondere der Strahlformungsoptik 6 beschrieben.

Allgemein dient die Strahlformungsoptik 6 dazu, aus dem Rohstrahl 4 den Sammel-Ausgabestrahl 7, welcher auch als Transportstrahl bezeichnet wird, zu formen. Der Sammel-Ausgabestrahl 7 wird von der Auskoppeloptik 8 in die Einzel-Ausgabestrahlen $9_i$, welche zu unterschiedlichen Scannern geführt werden, aufgeteilt.

Der Transportstrahl kann leicht über große Distanzen transportiert werden. Hierfür ist es von Vorteil, dass der Transportstrahl eine sehr kleine Divergenz aufweist. Dies ist vorteilhaft, da der Abstand zwischen der Strahlformungsoptik 6 und den Scannern, insbesondere den Beleuchtungsoptiken 15 der Scanner, nicht notwendigerweise bekannt sein muss.

Um den Transportstrahl leichter auf die Scanner aufteilen zu können, ist es von Vorteil, wenn er kein gaußförmiges Profil, wie es üblicherweise für den Rohstrahl 4 der Fall ist, sondern ein im Wesentlichen homogenes Intensitätsprofil aufweist. Dies kann, wie vorgehend beschrieben, durch die Strahlformungsoptik 6, insbesondere mittels Reflexion an Freiformflächen, erreicht werden.

Ein Sammel-Ausgabestrahl 7 mit einem homogenen Intensitätsprofil erleichtert es, den Sammel-Ausgabestrahl 7 gleichmäßig in die unterschiedlichen Einzel-Ausgabestrahlen $9_i$ aufzuteilen. Erfindungsgemäß wurde jedoch erkannt, dass die Homogenitätsanforderung nicht zwingend notwendig ist, um eine Dosisstabilität der Einzelscanner zu erreichen. Weiterhin wurde erkannt, dass der Sammel-Ausgabestrahl 7 nicht notwendigerweise ein rechteckiges Intensitätsprofil aufweisen muss.

Gemäß einer Variante umfasst die Strahlformungsoptik 6 Spiegel, deren Reflexionsflächen nicht als Freiformflächen ausgebildet sind. Es ist insbesondere möglich, die Strahlformungsoptik 6 derart auszubilden, dass sie ausschließlich Spiegel umfasst, deren Reflexionsflächen nicht als Freiformflächen ausgebildet sind.

Die Auskoppeloptik 8 und die Umlenkoptik 13 umfassen insbesondere ausschließlich Spiegel, welche in streifendem Einfall mit der Beleuchtungsstrahlung 3 beaufschlagt werden. Die Umlenkung der Beleuchtungsstrahlung 3 um den insgesamt gewünschten Umlenkwinkel geschieht insbesondere mit Hilfe einer Mehrzahl von Reflexionen. Die Gesamtzahl der Reflexionen in der Auskoppeloptik 8 und der Umlenkoptik 13 beträgt insbesondere mindestens 2, insbesondere mindestens 3, insbesondere mindestens 4.

Die Strahlformungsoptik 6 ist zwischen der Strahlungsquelle 2 und der Auskoppeloptik 8, das heißt dem optischen Bauelement, mittels welchem der Sammel-Ausgabestrahl 7 in Einzel-Ausgabestrahlen $9_i$ aufgeteilt wird, angeordnet.

Die Strahlformungsoptik 6 ist insbesondere derart ausgebildet, dass der Rohstrahl 4 in mindestens einer Richtung senkrecht zur Ausbreitungsrichtung vergrößert wird. Die Strahlformungsoptik 6 ist insbesondere derart ausgebildet, dass der Querschnitt des Rohstrahls 4 in mindestens einer Richtung, insbesondere in zwei, schräg, insbesondere senkrecht zueinander verlaufenden Richtungen vergrößert wird. Der Vergrößerungsmaßstab liegt vorzugsweise im Bereich zwischen 1:4 und 1:50, insbesondere bei mindestens 1:6, insbesondere bei mindestens 1:8, insbesondere mindestens 1:10.

Am Eingang der Strahlformungsoptik 6 weist der Rohstrahl 4 insbesondere einen Querschnitt mit einem Durchmesser im Bereich von 1 mm bis 10 mm auf. Am Ausgang der Strahlformungsoptik 6 weist der Sammel-Ausgabestrahl 7 insbesondere einen Durchmesser im Bereich von 15 mm bis 300 mm, insbesondere von mindestens 30 mm, insbesondere mindestens 50 mm auf.

Am Eingang der Strahlformungsoptik 6 weist der Rohstrahl 4 insbesondere eine Divergenz im Bereich von 25 $\mu$rad bis 100 $\mu$rad auf. Am Ausgang der Strahlformungsoptik 6 ist die Divergenz des Sammel-Ausgabestrahls 7 insbesondere kleiner als 10 $\mu$rad.

Die Strahlformungsoptik 6 ist insbesondere telezentrisch. Sie umfasst mindestens zwei optisch wirksame Flächen. Diese werden vorzugsweise in streifendem Einfall betrieben.

Vorzugsweise wird der Rohstrahl 4 in zwei schräg, insbesondere senkrecht aufeinander stehenden Richtungen vergrößert. In diesem Fall umfasst die Strahlformungsoptik 6 mindestens zwei Gruppen mit jeweils mindestens zwei optisch wirksamen Flächen, das heißt insbesondere mindestens vier optisch wirksamen Flächen. Die Strahlformungsoptik 6 umfasst insbesondere die Spiegelgruppen 27, 28. Die Spiegelgruppen 27, 28 umfassen insbesondere jeweils zwei Spiegel $27_i$, $28_i$.

Die Strahlformungsoptik 6 umfasst insbesondere mindestens eine Strahlformungs-Spiegelgruppe 27, 28 mit jeweils mindestens zwei Spiegeln $27_i$, $28_i$. Die Spiegel $27_i$, $28_i$ können jeweils ein Oberflächenprofil aufweisen, welches entlang einer lokalen Koordinate konstant ist und entlang einer hierzu orthogonalen Koordinate einen sphärischen Verlauf besitzt. Dies führt zu einer Vergrößerung des Rohstrahls 4 in lediglich einer einzigen Richtung. Es ist möglich, zwei derartige Spiegelgruppen 27, 28 zu verwenden, um den Rohstrahl 4 in zwei unterschiedlichen, insbesondere zwei orthogonalen Richtungen zu vergrößern.

Die Spiegel $27_i$, $28_i$ können auch entlang einer ersten lokalen Koordinate einen sphärischen Verlauf mit einem Krümmungsradius $R_1$ und entlang einer hierzu orthogonalen Koordinate einen sphärischen Verlauf mit einem Krümmungsradius $R_2$ aufweisen. $R_1$ und $R_2$ können hierbei identisch oder verschieden sein. Eine derartige Variante führt zu einer Vergrößerung des Rohstrahls 4 in zwei aufeinander senkrecht stehenden Richtungen.

Die Spiegel $27_i$, $28_i$ können auch jeweils ein Oberflächenprofil aufweisen, welches einem Ellipsoiden entspricht. Auch dies führt zu einer Vergrößerung in zwei Richtungen.

Vorzugsweise ist die Strahlformungsoptik 6 derart angeordnet und ausgebildet, dass der Rohstrahl, insbesondere dessen Querschnitt, in Bezug auf eine Richtung, welche parallel zum Erdboden, das heißt parallel zu einer Horizontalrichtung läuft, vergrößert wird. Die Strahlformungsoptik 6 ist insbesondere derart ausgebildet, dass der Sammel-Ausgabestrahl 7 am Ausgang der Strahlformungsoptik 6 parallel zum Erdboden verläuft.

Im Folgenden werden weitere Aspekte und Varianten der Strahlformungsoptik 6 stichwortartig beschrieben.

Wie vorhergehend beschrieben wurde, ist es nicht zwingend notwendig, dass der Rohstrahl 4 mittels der Strahlformungsoptik 6 homogenisiert wird. Eine Homogenisierung des Rohstrahls 4 kann jedoch vorteilhaft sein. Sie kann insbesondere zu einer höheren Materiallebensdauer führen. Sie kann auch die Herstellbarkeit, insbesondere der Auskoppeloptik 8, vereinfachen.

Je nachdem, welcher Aspekt im Vordergrund steht, kann es sinnvoll und vorgesehen sein, den Rohstrahl 4 lediglich in einer Richtung zu homogenisieren. Diesbezüglich wurde erkannt, dass sich eine Homogenisierung des Rohstrahls 4 in einer Richtung positiv auf die Materiallebensdauer auswirkt, während eine Homogenisierung in einer hierzu orthogonalen Richtung vorteilhaft für die Herstellbarkeit, insbesondere der Auskoppeloptik 8, ist.

Da, wie vorhergehend beschrieben wurde, die Strahlformungsoptik 6 für diese beiden Richtungen jeweils getrennte Gruppen 27, 28 von Spiegeln $27_i$, $28_i$, insbesondere separate Spiegelpaare aufweist, kann beispielsweise eines der Spiegelpaare als Tori, das andere als Freiformflächen ausgeführt sein. Dies führt zu einer Kostenersparnis.

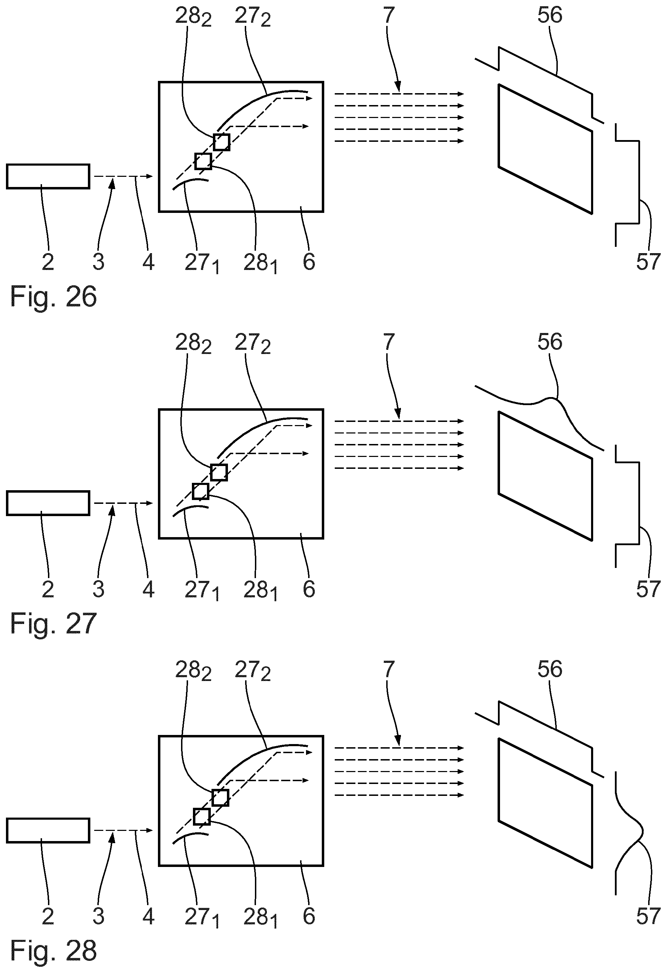

Unterschiedliche Varianten der Homogenisierung des Rohstrahls 4 mittels der Strahlformungsoptik 6 sind schematisch in den Figuren 26 bis 28 dargestellt. In der Figur 26 ist schematisch die Ausführung einer Strahlformungsoptik 6 dargestellt, mittels welcher der Rohstrahl 4 in zwei aufeinander senkrecht stehenden Richtungen homogenisiert wird. Dies ist durch einen stufenförmigen Verlauf eines Intensitätsprofils 56 in einer ersten Richtung und einen stufenförmigen Verlauf eines Intensitätsprofils 57 in einer zweiten Richtung verdeutlicht. Die Intensitätsprofile 56, 57 beziehen sich auf die Intensität der Beleuchtungsstrahlung 3 in einem Querschnitt des Sammel-Ausgabestrahls 7 senkrecht zu dessen Ausbreitungsrichtung.

In der Figur 27 ist eine Variante der Strahlformungsoptik 6 dargestellt, bei welcher der Rohstrahl 4 lediglich in der zweiten Richtung homogenisiert wird. Dementsprechend weist das Intensitätsprofil 57 einen stufenförmigen Verlauf auf. Das Intensitätsprofil 56 weist einen inhomogenen, insbesondere einen nicht-stufenförmigen, insbesondere einen gaußförmigen Verlauf auf. Mit anderen Worten kommt es zu einer lokalen Intensitätserhöhung in einem Mittenbereich des Sammel-Ausgabestrahls 7, welcher in der Figur 27 in Vertikalrichtung verläuft.

In der Figur 28 ist entsprechend eine Variante der Strahlformungsoptik 6 dargestellt, bei welcher im Vergleich zur Ausführungsform gemäß Figur 27 der Rohstrahl 4 gerade in der anderen Richtung homogenisiert ist. Bei dieser Ausführungsform weist das Intensitätsprofil 56 in der ersten Richtung einen stufenförmigen Verlauf auf. Das Intensitätsprofil 57 in der zweiten Richtung ist nicht homogen, insbesondere nicht-stufenförmig, insbesondere gaußförmig. Die Intensität ist in einem horizontal verlaufenden Mittenbereich erhöht.

Es sind auch Zwischenstufen möglich. Es ist insbesondere möglich, den Rohstrahl 4 in einer oder beiden Richtungen teilweise zu homogenisieren. Es ist insbesondere möglich, den Rohstrahl 4 in einer oder beiden Richtungen derart zu homogenisieren, dass sich die Intensität der Beleuchtungsstrahlung an verschiedenen Ortskoordinaten in dieser Richtung jeweils nur noch um maximal 25 % unterscheidet. Durch eine entsprechende Homogenisierung können insbesondere Intensitätsspitzen vermieden werden. Dies wirkt sich insbesondere vorteilhaft auf die Materiallebensdauer aus.

Das Intensitätsprofil 56 und/oder das Intensitätsprofil 57 kann insbesondere eine Form aufweisen, welche weder exakt gaußförmig noch exakt stufenförmig ist, sondern einen gaußförmigen und einen stufenförmigen Anteil aufweist. Das Intensitätsprofil 56 und/oder das Intensitätsprofil 57 lässt sich insbesondere als Summe eines gaußförmigen Anteils und eines stufenförmigen Anteils beschreiben.

Eine Inhomogenität des Sammel-Ausgabestrahls 7 in der zweiten Richtung kann dadurch kompensiert werden, dass die Bereiche des Sammel-Ausgabestrahls 7, welche von der Auskoppeloptik 8 in die unterschiedlichen Einzel-Ausgabestrahlen $9_i$ ausgekoppelt werden, unterschiedlich groß sind. Durch die Größe dieser Bereiche ist es möglich, vorzugeben, welcher Anteil mit der Beleuchtungsstrahlung 3 im Sammel-Ausgabestrahl 7 zu den einzelnen Scannern geführt wird.

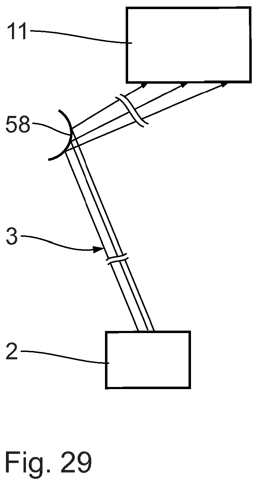

In der Figur 29 ist ein optisches Element zur Vergrößerung des Querschnitts eines Strahls mit Beleuchtungsstrahlung 3 dargestellt. Zur Vergrößerung des Strahlquerschnitts ist im Strahlengang der Beleuchtungsstrahlung 3 ein Spiegel 58 mit einer konvexen Reflexionsfläche angeordnet. Der Spiegel 58 wird auch als Zerstreuungsspiegel bezeichnet.

Der Spiegel 58 kann eine im Wesentlichen zylinderförmige Reflexionsfläche aufweisen, das heißt in einer ersten Richtung konvex und in einer zweiten, zur ersten Richtung senkrecht verlaufenden Richtung plan sein. Er kann auch in beide Richtungen konvex sein. Hierbei können die Krümmungsradien identisch oder unterschiedlich sein. Prinzipiell ist es auch möglich, den Spiegel 58 mit verstellbaren, insbesondere aktuatorisch verstellbaren Krümmungsradien auszubilden. Durch die Auswahl der Krümmungsradien des Spiegels 58 bezüglich der ersten Richtung und der hierzu senkrechten zweiten Richtung kann die Vergrößerung des Querschnitts in die entsprechenden Richtungen gezielt beeinflusst werden.

Der Spiegel 58 kann somit zur gezielten Vergrößerung des Querschnitts des Strahls bzw. des Strahlenbündels mit Beleuchtungsstrahlung 3 verwendet werden.

**Patentansprüche**

1. Strahlführungsoptik (10) für ein Beleuchtungssystem für die EUV-Projektionslithographie mit einer Fokussier-Baugruppe (14; 41; 45; 46; 49; 52; 55), die einen EUV-Einzel-Ausgabestrahl ($9_i$) in einen Zwischenfokus (42) der Strahlführungsoptik (10) überführt, **dadurch gekennzeichnet, dass** die Fokussier-Baugruppe (14; 41; 45, 46; 49; 52; 55) derart ausgeführt ist, dass für ein Verhältnis b/a aus einer kleinen Halbachse b eines Ellipsoid-Spiegels (47; 50; 54) und einer großen Halbachse a des Ellipsoid-Spiegels (47; 50; 54) gilt: 0,7 NA < b/a < 0,9 NA, wobei NA die numerische Apertur im Zwischenfokus (42) der Fokussier-Baugruppe (14; 41; 45, 46; 49; 52; 55) bezeichnet.

2. Strahlführungsoptik (10) nach Anspruch 1, **dadurch gekennzeichnet, dass** die Fokussier-Baugruppe (14; 41; 45,

46; 49; 52; 55) mindestens zwei Spiegel (47, 48; 50; 51; 53, 54), nämlich

- mindestens einen Ellipsoid-Spiegel (47; 50; 54) einerseits und
- mindestens einen Paraboloid-Spiegel (53) oder mindestens einen Hyperboloid-Spiegel (48; 51) andererseits aufweist.

3. Strahlführungsoptik (10) nach Anspruch 2, **dadurch gekennzeichnet, dass** die mindestens zwei Spiegel (47, 48; 50; 51; 53, 54) der Fokussier-Baugruppe (14; 41; 45, 46; 49; 52; 55) sequentiell im Strahlengang des EUV-Einzel-Ausgabestrahls ($9_i$) angeordnet sind.

4. Strahlführungsoptik (10) nach einem der vorhergehenden Ansprüche, **dadurch gekennzeichnet, dass** die Fokussier-Baugruppe (14; 41; 45, 46; 49; 52; 55) nach Art einer Wolter-Spiegelgruppe vom Typ I, vom Typ II oder vom Typ III ausgeführt ist.

5. Strahlführungsoptik (10) nach einem der vorhergehenden Ansprüche, **dadurch gekennzeichnet, dass** ein Bauraum der Fokussier-Baugruppe (14; 41; 45, 46; 49; 52; 55) längs eines Strahlweges des EUV-Einzel-Ausgabestrahls ($9_i$) etwa doppelt so groß ist wie eine große Halbachse eines Ellipsoid-Spiegels (47; 50; 54) der Fokussier-Baugruppe (14; 41; 45, 46; 49; 52; 55).

6. Strahlführungsoptik (10) nach einem der vorhergehenden Ansprüche, **dadurch gekennzeichnet, dass** die Fokussier-Baugruppe (14; 41; 45, 46; 49; 52; 55) derart ausgeführt ist, dass ein Bauraum der Fokussier-Baugruppe (14; 41; 45, 46; 49; 52; 55) längs eines Strahlwegs des EUV-Einzel-Ausgabestrahls ($9_i$) etwa fünfzig Mal so groß ist wie ein Durchmesser des EUV-Einzel-Ausgabestrahls ($9_i$) beim Eintritt in die Fokussier-Baugruppe (14; 41; 45, 46; 49; 52; 55).

7. Strahlführungsoptik (10) nach einem der vorhergehenden Ansprüche, **dadurch gekennzeichnet, dass** die Fokussier-Baugruppe (14; 41; 45, 46; 49; 52; 55) derart ausgeführt ist, dass sie mindestens einen Ellipsoid-Spiegel (47; 50; 54) einerseits und mindestens einen Paraboloid-Spiegel (53) andererseits aufweist, wobei für ein Verhältnis a/f aus einer großen Halbachse a des Ellipsoid-Spiegels (47; 50; 54) und einer Brennweite f des Paraboloid - Spiegels (47; 50; 54) gilt: a/f > 50.

8. Strahlführungsoptik (10) nach einem der vorhergehenden Ansprüche, **dadurch gekennzeichnet, dass** die Fokussier-Baugruppe (14; 41; 45, 46; 49; 52; 55) derart ausgeführt ist, dass ein geringster Ablenkwinkel, den ein Randstrahl des EUV-Einzel-Ausgabestrahls ($9_i$) durch die Fokussier-Baugruppe (14; 41; 45, 46; 49; 52; 55) erfährt, nicht größer ist als 5°.

9. Beleuchtungssystem für die EUV-Projektionslithographie

- mit einer Strahlformungsoptik (6) zur Erzeugung eines EUV-Sammel-Ausgabestrahls (7) aus einem EUV-Rohstrahl (4) einer synchrotron-strahlungsbasierten Lichtquelle (2),
- mit einer Auskoppeloptik (8) zur Erzeugung mehrerer EUV-Einzel-Ausgabestrahlen ($9_i$) aus dem EUV-Sammel-Ausgabestrahl (7),
- mit jeweils einer Strahlführungsoptik (10) nach einem der vorhergehenden Ansprüche zur Führung des jeweiligen EUV-Einzel-Ausgabestrahls ($9_i$) hin zu einem Objektfeld (11), in dem eine Lithographiemaske (12) anordenbar ist.

10. Beleuchtungssystem nach Anspruch 9, **dadurch gekennzeichnet, dass** die Strahlformungsoptik (6) zur Erzeugung des EUV-Sammel-Ausgabestrahls (7) mit einem Aspektverhältnisbeitrag von $1 : \sqrt{N}$ ausgeführt ist, wobei die Auskoppeloptik (8) und/oder die Strahlführungsoptik (10) zur nachfolgenden Erzeugung einer Anzahl N der EUV-Einzel-Ausgabestrahlen ($9_1$, $9_N$) mit einem Aspektverhältnisbeitrag von jeweils 1:1 ausgeführt sind.

11. Beleuchtungssystem nach Anspruch 9 oder 10 mit einer EUV-Lichtquelle (2).

12. Projektionsbelichtungsanlage (1) für die EUV-Lithographie

- mit einem Beleuchtungssystem nach einem der Ansprüche 9 bis 11,

- mit einem Retikelhalter (20) zur Halterung eines mit Beleuchtungslicht (3) des optischen Systems zu beaufschlagenden Retikels (12) in dem Objektfeld (11),
- mit der Projektionsoptik (19) zur Abbildung des Beleuchtungsfeldes (11) in ein Bildfeld (22) in einer Bildebene (23),
- mit einem Waferhalter (25) zur Halterung eines Wafers (24) in der Bildebene (23) derart, dass bei einer Projektionsbelichtung im Objektfeld (11) angeordnete Retikel-Strukturen auf einen im Bildfeld (22) angeordneten Waferabschnitt abgebildet werden.

13. Verfahren zur Herstellung eines strukturierten Bauteils mit folgenden Verfahrensschritten:

- Bereitstellen eines Retikels (12) und eines Wafers (24),
- Projizieren einer Struktur auf dem Retikel (12) auf eine lichtempfindliche Schicht des Wafers (24) mit Hilfe der Projektionsbelichtungsanlage (1) nach Anspruch 12,
- Erzeugen einer Mikro- bzw. Nanostruktur auf dem Wafer (24).

## Claims

1. Beam guiding optical unit (10) for an illumination system for EUV projection lithography having a focusing assembly (14; 41; 45; 46; 49; 52; 55), which transfers an EUV individual output beam ($9_i$) into an intermediate focus (42) of the beam guiding optical unit (10), **characterized in that** the focusing assembly (14; 41; 45, 46; 49; 52; 55) is designed such that the following applies for a ratio b/a of a small half-axis b of an ellipsoid mirror (47; 50; 54) and a large half-axis a of the ellipsoid mirror (47; 50; 54): 0.7 NA < b/a < 0.9 NA, wherein NA designates the numeric aperture in the intermediate focus (42) of the focusing assembly (14; 41; 45, 46; 49; 52; 55).

2. Beam guiding optical unit (10) according to Claim 1, **characterized in that** the focusing assembly (14; 41; 45, 46; 49; 52; 55) has at least two mirrors (47, 48; 50; 51; 53, 54), namely

   - at least one ellipsoid mirror (47; 50; 54), on the one hand and
   - at least one paraboloid mirror (53) or at least one hyperboloid mirror (48; 51), on the other hand.

3. Beam guiding optical unit (10) according to Claim 2, **characterized in that** the at least two mirrors (47, 48; 50; 51; 53, 54) of the focusing assembly (14; 41; 45, 46; 49; 52; 55) are arranged sequentially in the beam path of the EUV individual output beam ($9_i$).

4. Beam guiding optical unit (10) according to any one of the preceding claims, **characterized in that** the focusing assembly (14; 41; 45, 46; 49; 52; 55) is designed like a Wolter mirror group of type I, of type II, or of type III.

5. Beam guiding optical unit (10) according to any one of the preceding claims, **characterized in that** an installation space of the focusing assembly (14; 41; 45, 46; 49; 52; 55) along a beam path of the EUV individual output beam ($9_i$) is approximately twice as large as a large half-axis of an ellipsoid mirror (47; 50; 54) of the focusing assembly (14; 41; 45, 46; 49; 52; 55).

6. Beam guiding optical unit (10) according to any one of the preceding claims, **characterized in that** the focusing assembly (14; 41; 45, 46; 49; 52; 55) is designed such that an installation space of the focusing assembly (14; 41; 45, 46; 49; 52; 55) along a beam path of the EUV individual output beam ($9_i$) is approximately 50 times as large as a diameter of the EUV individual output beam ($9_i$) upon entering the focusing assembly (14; 41; 45, 46; 49; 52; 55).

7. Beam guiding optical unit (10) according to any one of the preceding claims, **characterized in that** the focusing assembly (14; 41; 45, 46; 49; 52; 55) is designed such that it has at least one ellipsoid mirror (47; 50; 54), on the one hand, and at least one paraboloid mirror (53), on the other hand, wherein the following applies for a ratio a/f of a large half-axis a of the ellipsoid mirror (47; 50; 54) and a focal length f of the paraboloid mirror (47; 50; 54): a/f > 50.

8. Beam guiding optical unit (10) according to any one of the preceding claims, **characterized in that** the focusing assembly (14; 41; 45, 46; 49; 52; 55) is designed such that a smallest deflection angle which an edge beam of the EUV individual output beam ($9_i$) experiences due to the focusing assembly (14; 41; 45, 46; 49; 52; 55) is not greater than 5°.

9. Illumination system for EUV projection lithography

- having a beamforming optical unit (6) for generating an EUV collective output beam (7) from an EUV raw beam (4) of a synchrotron radiation-based light source (2),
- having a decoupling optical unit (8) for generating multiple EUV individual output beams ($9_i$) from the EUV collective output beam (7),
- having in each case a beam guiding optical unit (10) according to any one of the preceding claims for guiding the respective EUV individual output beam ($9_i$) toward an object field (11), in which a lithography mask (12) is arrangeable.

10. Illumination system according to Claim 9, **characterized in that** the beamforming optical unit (6) is designed to generate the EUV collective output beam (7) having an aspect ratio contribution of $1 : \sqrt{N}$ , wherein the decoupling optical unit (8) and/or the beam guiding optical unit (10) are designed to subsequently generate a number N of the EUV individual output beams ($9_1$, $9_N$) having an aspect ratio contribution of 1:1 in each case.

11. Illumination system according to Claim 9 or 10 having an EUV light source (2).

12. Projection exposure facility (1) for EUV lithography

- having an illumination system according to any one of Claims 9 to 11,
- having a reticle holder (20) for holding a reticle (12) to be subjected to illumination light (3) of the optical system in the object field (11),
- having the projection optical unit (19) for imaging the illumination field (11) in an image field (22) in an image plane (23),
- having a wafer holder (25) for holding a wafer (24) in the image plane (23) such that during a projection exposure, reticle structures arranged in the object field (11) are imaged on a wafer section arranged in the image field (22).

13. Method for producing a structured component having the following method steps:

- providing a reticle (12) and a wafer (24),
- projecting a structure on the reticle (12) on a light-sensitive layer of the wafer (24) with the aid of the projection exposure facility (1) according to Claim 12,
- generating a microstructure or nanostructure on the wafer (24).

**Revendications**

1. Optique de guidage de faisceau (10) destinée à un système d'éclairage pour la lithographie par projection EUV comprenant un sous-ensemble de focalisation (14 ; 41 ; 45 ; 46 ; 49 ; 52 ; 55), qui achemine un faisceau de sortie individuel EUV ($9_i$) vers un foyer intermédiaire (42) de l'optique de guidage de faisceau (10), **caractérisée en ce que** le sous-ensemble de focalisation (14 ; 41 ; 45, 46 ; 49 ; 52 ; 55) est réalisé de telle sorte que pour un rapport b/a entre un demi-petit axe b d'un miroir ellipsoïdal (47 ; 50 ; 54) et un demi-grand axe a du miroir ellipsoïdal (47 ; 50 ; 54), on a : 0,7 NA < b/a < 0,9 NA, où NA désigne l'ouverture numérique au foyer intermédiaire (42) du sous-ensemble de focalisation (14 ; 41 ; 45, 46 ; 49 ; 52 ; 55).

2. Optique de guidage de faisceau (10) selon la revendication 1, **caractérisée en ce que** le sous-ensemble de focalisation (14 ; 41 ; 45, 46 ; 49 ; 52 ; 55) comprend au moins deux miroirs (47, 48 ; 50 ; 51 ; 53, 54), à savoir

- d'une part, au moins un miroir ellipsoïdal (47 ; 50 ; 54) et
- d'autre part, au moins un miroir paraboloïde (53) ou au moins un miroir hyperboloïde (48 ; 51).

3. Optique de guidage de faisceau (10) selon la revendication 2, **caractérisé en ce que** lesdits au moins deux miroirs (47, 48 ; 50 ; 51 ; 53, 54) du sous-ensemble de focalisation (14 ; 41 ; 45, 46 ; 49 ; 52 ; 55) sont agencés de manière séquentielle sur le chemin de faisceau du faisceau de sortie individuel EUV ($9_i$).

4. Optique de guidage de faisceau (10) selon l'une des revendications précédentes, **caractérisé en ce que** le sous-ensemble de focalisation (14 ; 41 ; 45, 46 ; 49 ; 52 ; 55) est réalisé sous la forme d'un groupe de miroirs de Wolter de type I, de type II ou de type III.

**5.** Optique de guidage de faisceau (10) selon l'une des revendications précédentes, **caractérisé en ce qu'**un encombrement du sous-ensemble de focalisation (14 ; 41 ; 45, 46 ; 49 ; 52 ; 55) le long d'un chemin de faisceau du faisceau de sortie individuel EUV ($9_i$) est environ deux fois plus grand qu'un demi-grand axe d'un miroir ellipsoïdal (47 ; 50 ; 54) du sous-ensemble de focalisation (14 ; 41 ; 45, 46 ; 49 ; 52 ; 55).

**6.** Optique de guidage de faisceau (10) selon l'une des revendications précédentes, **caractérisé en ce que** le sous-ensemble de focalisation (14 ; 41 ; 45, 46 ; 49 ; 52 ; 55) est réalisé de telle sorte qu'un encombrement du sous-ensemble de focalisation (14 ; 41 ; 45, 46 ; 49 ; 52 ; 55) le long d'un chemin de faisceau du faisceau de sortie individuel EUV ($9_i$) est environ cinquante fois plus grand qu'un diamètre du faisceau de sortie individuel EUV ($9_i$) à l'entrée du sous-ensemble de focalisation (14 ; 41 ; 45, 46 ; 49 ; 52 ; 55).

**7.** Optique de guidage de faisceau (10) selon l'une des revendications précédentes, **caractérisé en ce que** le sous-ensemble de focalisation (14 ; 41 ; 45, 46 ; 49 ; 52 ; 55) est réalisé de telle sorte qu'il comprend d'une part, au moins un miroir ellipsoïdal (47 ; 50 ; 54) et d'autre part, au moins un miroir paraboloïde (53), dans lequel, pour un rapport a/f entre un demi-grand axe a du miroir ellipsoïdal (47 ; 50 ; 54) et une distance focale f du miroir paraboloïde (47 ; 50 ; 54), on a : a/f > 50.

**8.** Optique de guidage de faisceau (10) selon l'une des revendications précédentes, **caractérisé en ce que** le sous-ensemble de focalisation (14 ; 41 ; 45, 46 ; 49 ; 52 ; 55) est réalisé de telle sorte qu'un plus petit angle de déviation qu'un rayon marginal du faisceau de sortie individuel EUV ($9_i$) subit à travers le sous-ensemble de focalisation (14 ; 41 ; 45, 46 ; 49 ; 52 ; 55) n'est pas supérieur à 5°.

**9.** Système d'éclairage pour la lithographie par projection EUV

  - comprenant une optique de mise en forme de faisceau (6) destinée à générer un faisceau de sortie collectif EUV (7) à partir d'un faisceau brut EUV (4) provenant d'une source de lumière à base de rayonnement synchrotron (2),
  - comprenant une optique de découplage (8) destinée à générer plusieurs faisceaux de sortie individuels EUV ($9_i$) à partir du faisceau de sortie collectif EUV (7),
  - comprenant respectivement une optique de guidage de faisceau (10) selon l'une des revendications précédentes destinée à guider le faisceau de sortie individuel EUV ($9_i$) respectif vers un champ objet (11) dans lequel peut être agencé un masque de lithographie (12).

**10.** Système d'éclairage selon la revendication 9, **caractérisé en ce que** l'optique de mise en forme de faisceau (6) destinée à générer le faisceau de sortie collectif EUV (7) est réalisée avec la contribution d'un rapport de forme de

$$1 : \quad \sqrt{N}$$

, l'optique de découplage (8) et/ou l'optique de guidage de faisceau (10) destinée à générer ensuite un nombre N des faisceaux de sortie individuels EUV ($9_1$, $9_N$) étant respectivement réalisées avec une contribution d'un rapport de forme de 1:1.

**11.** Système d'éclairage selon la revendication 9 ou 10 comprenant une source de lumière EUV (2).

**12.** Installation d'exposition par projection (1) pour la lithographie EUV

  - comprenant un système d'éclairage selon l'une des revendications 9 à 11,
  - comprenant un porte-réticule (20) destiné à maintenir un réticule (12) devant être exposé à une lumière d'éclairage (3) du système optique dans le champ objet (11),
  - comprenant l'optique de projection (19) destinée à former l'image du champ d'éclairage (11) dans un champ d'image (22) sur un plan image (23),
  - comprenant un porte-plaquette (25) destiné à maintenir une plaquette (24) dans le plan image (23) de telle sorte que, lors d'une exposition par projection, des structures de réticule agencées dans le champ objet (11) sont projetées sur une partie de plaquette agencée dans le champ image (22).

**13.** Procédé de fabrication d'un composant structuré comprenant les étapes de procédé suivantes :

  - mise à disposition d'un réticule (12) et d'une plaquette (24),
  - projection d'une structure présente sur le réticule (12) sur une couche photosensible de la plaquette (24) à l'aide de l'installation d'exposition par projection (1) selon la revendication 12,
  - génération d'une micro- ou nanostructure sur la plaquette (24).

Fig. 1

EP 3 467 590 B1

Fig. 2

Fig. 3

Fig. 4

Fig. 5

Fig. 6

Fig. 7

Fig. 8

Fig. 9

BS1,
27₁  BS2,  BS3,  30  7
    27₂  28₁

α  x
β  y  z

3  4

BS4,  BS5,
28₂  27₃

Fig. 10

BS2,  BS3,  30  BS5,  7
27₂  28₁  27₃

α  y
γ  β  x  z

3  4  BS1,  BS4,
    27₁  28₂

Fig. 11

$9_1$

13

$9_1$

x

y z

$\alpha$

7 3 $31_1$ 32 $31_2$ 32 $31_3$

Fig. 12

13

x

y z

D6

D5

D4

D3

D2

3,9 D1 34

Fig. 13

Fig. 14

Fig. 15

Fig. 16

Fig. 17

Fig. 18

Fig. 19

43  42                    44

$2\delta$                    3,9$_i$

CR

41

x

y     z

9$_i$

13

Fig. 20

43  42                    44

3,9$_i$

$2\delta$

CR

46a   $\alpha$

x

y     z                    45

9$_i$

CR

Fig. 21

Fig. 22

Fig. 23

Fig. 24

Fig. 25

Fig. 26

Fig. 27

Fig. 28

Fig. 29

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 20110014799 A1
- WO 2009121438 A1
- US 20090174876 A1
- US 6438199 B1
- US 6658084 B2
- DE 10358225 B3
- US 6859515 B
- US 20030002022 A1
- DE 102009025655 A1
- US 6700952 B
- US 20040140440 A
- US 20030043359 A1
- US 5896438 A
- US 20050243297 A1
- DE 102008014832 A1
- EP 1225481 A2
- US 20070152171 A1
- EP 1072957 A2
- US 6198793 B1

### In der Beschreibung aufgeführte Nicht-Patentliteratur

- **UWE SCHINDLER**. Ein supraleitender Undulator mit elektrisch umschaltbarer Helizität. *Forschungszentrum Karlsruhe in der Helmholtz-Gemeinschaft, wissenschaftliche Berichte, FZKA 6997*, August 2004
- **H.WOLTER**. Spiegelsysteme streifenden Einfalls als abbildende Optiken für Röntgenstrahlen. *Annalen der Physik*, 1952, vol. 10, 94-114